(19) Europäisches Patentamt
European Patent Office
Office européen des brevets

(11) **EP 4 137 345 B1**

(12) **EUROPEAN PATENT SPECIFICATION**

(45) Date of publication and mention
of the grant of the patent:
**09.04.2025  Bulletin 2025/15**

(21) Application number: **22158579.7**

(22) Date of filing: **24.02.2022**

(51) International Patent Classification (IPC):
*B60L 3/00* (2019.01)       *B60L 58/10* (2019.01)
*B60L 58/16* (2019.01)       *G01R 31/36* (2020.01)
*H01M 10/48* (2006.01)

(52) Cooperative Patent Classification (CPC):
**B60L 58/16; B60L 3/0046; B60L 58/10;
G01R 31/3648; G01R 31/367; G01R 31/382;
H01M 10/42; H01M 10/48; H01M 10/486;
B60L 2240/545; B60L 2240/547; B60L 2240/549;
B60L 2240/622; B60L 2260/52; H01M 2220/20**

(54) **METHOD AND SYSTEM FOR ESTIMATING DYNAMIC CAPACITY OF A BATTERY FOR AN ELECTRIC VEHICLE**

VERFAHREN UND SYSTEM ZUR ABSCHÄTZUNG DER DYNAMISCHEN KAPAZITÄT EINER BATTERIE FÜR EIN ELEKTROFAHRZEUG

PROCÉDÉ ET SYSTÈME D'ESTIMATION DE CAPACITÉ DYNAMIQUE D'UNE BATTERIE D'UN VÉHICULE ÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **19.08.2021  IN 202141037569**

(43) Date of publication of application:
**22.02.2023  Bulletin 2023/08**

(73) Proprietor: **Hitachi, Ltd.**
**Tokyo 100-8280 (JP)**

(72) Inventors:
• **Jagadeeswaran, Subramanian**
  **560055 Bangalore (IN)**
• **Ragesh, R**
  **560055 Bangalore (IN)**
• **Vinod Raj, Nandanakrishnan**
  **560055 Bangalore (IN)**

(74) Representative: **MERH-IP Matias Erny Reichl
Hoffmann
Patentanwälte PartG mbB
Paul-Heyse-Straße 29
80336 München (DE)**

(56) References cited:
**EP-A1- 3 283 893       EP-A2- 2 680 395
EP-B1- 3 283 893       US-A1- 2015 070 024
US-A1- 2021 242 510**

**Description**

## TECHNICAL FIELD

The present subject matter is related in general to systems implemented in an electric vehicle, more particularly, but not exclusively the present subject matter relates to a method for estimating one or more dynamic capacities of a battery in an electric vehicle, for one or more usages of the electric vehicle.

## BACKGROUND

Currently, many commercial fleet operators are rapidly shifting to electric mobility. The electric mobility represents using electric power to enable electric propulsion of vehicles and fleets. The fleet operators have reported that one of the biggest challenges faced by the fleet operators is with respect to fleet deployment and maintenance. The challenges faced with respect to the fleet deployment and maintenance are estimating longevity and safety of battery of the vehicle. The longevity of the battery is a measure of performance and life of the battery. In the electric vehicle, a battery pack of the electric vehicle is most expensive and vulnerable component. A battery pack is a set of any number (preferably) identical batteries or individual battery cells. The battery pack of the electric vehicle is non-adequate to provide efficient performance generally beyond 80% battery health. The electric vehicle meets frequent break downs and requires high maintenance when battery health falls beyond the 80%. The electric vehicle may also meet some safety issues such as the electric vehicle may catch fire if the battery health falls below 60%.

Conventionally, capacity of the battery of the electric vehicle is less than value corresponding to State Of Health (SOH) of the battery. The SOH reflects ability of the battery to deliver and receive energy and power. The SOH can also be defined as an expected usable capacity of a battery. In real-time, actual output of the battery is less than the expected usable capacity due to one or more factors affecting the battery. The one or more factors may be internal resistance of the battery and losses of energy at varying operating conditions. The varying operating conditions of the battery may be charging of the battery and discharging of the battery. The battery capacity reduces due to high discharge rate, temperature, ageing of the battery and so on.

In conventional systems, estimation of available energy of the battery of the electric vehicle to predict range of the electric vehicle is based on the SOH of the battery. The conventional systems may assume available capacity of the battery pack is equivalent to the capacity indicated by the SOH of the battery. However, the actual output of the battery may be less than the SOH of the battery due to internal resistance, loss of energy due to heat, high discharge rate, temperature, ageing of the electric vehicle and so on. For example, the electric vehicle may get heated up from travelling a long distance due to internal resistance in the battery and the battery output may not be equal to the SOH. As, a result the electric vehicle may get stranded on road before reaching its destination. The actual output of the battery may be less than or equal to the SOH of the battery due to different usages of the electric vehicle. For example, the different usages of the electric vehicle may include, present usage of the electric vehicle, smoother usage of the electric vehicle and aggressive usage of the electric vehicle. Thus, there is a need for a system that may be capable of estimating the actual capacity of the battery that may be useable by the electric vehicle and also to predict longevity of the battery and breakdown index of the vehicle. Further background information may be found in EP 3 283 893 Al which discloses an apparatus configured for modelling a state of charge of a secondary electrochemical cell having a Lithium Sulfur chemistry in which capacity can be lost due to active reactant species becoming temporarily inactive in use, wherein the apparatus is configured such that a cell model module and/or a memory effect module adjusts a cell model module in use based on an operational history of a Lithium Sulfur cell to compensate for the prediction of the usable capacity of the cell by the memory effect module. Furthermore, US 2021/242 510 A1 discloses a battery management system for an electric vehicle, wherein a battery controller connected to the battery pack is configured to determine an estimated capacity of the battery cell or pack and to validate the estimated capacity. Eventually, US 2015/070 024 Al discloses a battery pack, wherein a state of health estimating unit is provided which is configured to estimate a state of health of at least one battery cell based on current capacity data and current internal resistance date According to EP2680395, there is provided a battery pack comprising: a rechargeable battery module; a battery management system for controlling charging/ discharging of the battery module; wherein the battery module comprises a substantially linear charging and discharging voltage-time profile within at least part of the charging and discharging cycle of the battery module; wherein the battery management system is arranged to calculate a state of charge of the battery module by using the linear charging/discharging characteristics of the battery module.

The information disclosed in this background of the disclosure section is only for enhancement of understanding of the general background of the invention and should not be taken as an acknowledgement or any form of suggestion that this information forms the prior art already known to a person skilled in the art.

## SUMMARY

The present invention is set out in the indepednent claims.

Preferred embodiments of the present invention are described in the dependent claims.

## BRIEF DESCRIPTION OF THE ACCOMPANYING DRAWINGS

The accompanying drawings, which are incorporated in and constitute a part of this disclosure, illustrate exemplary embodiments and, together with the description, serve to explain the disclosed principles. In the figures, the left-most digit(s) of a reference number identifies the figure in which the reference number first appears. The same numbers are used throughout the figures to reference like features and components. Some embodiments of system and/or methods in accordance with embodiments of the present subject matter are now described, by way of example only, and regarding the accompanying figures, in which:

**Figure 1** shows an exemplary environment of an estimation unit for estimating one or more dynamic capacities of a battery for an electric vehicle, in accordance with some embodiments of the present disclosure;

**Figure 2** shows a detailed block diagram of an estimation unit for estimating one or more dynamic capacities of a battery for an electric vehicle, in accordance with some embodiments of the present disclosure;

**Figures 3a, 3b** and **3d** show an exemplary embodiment for predicting ideal voltage profiles for one or more usages of the electric vehicle, in accordance with some embodiments of present disclosure; it is noted that Figures 3a, 3b and 3d are not encompassed by the wording of the claims but are considered as useful for understanding the invention.

**Figure 3c** shows an exemplary embodiment for predicting real-time voltage profile for current usage of the electric vehicle, in accordance with some embodiments of present disclosure; it is noted that Figure 3c is not encompassed by the wording of the claims but are considered as useful for understanding the invention.

**Figures 4a** and **4b** show an exemplary embodiment for estimating one or more dynamic capacities of a battery for an electric vehicle, for one or more usages, in accordance with some embodiments of present disclosure;

**Figure 5** shows an exemplary embodiment for determining longevity index of a battery for one or more usages, in accordance with some embodiments of present disclosure;

**Figure 6** shows an exemplary embodiment for predicting breakdown index of a battery for one or more usages, in accordance with some embodiments of present disclosure;

**Figure 7** illustrates a flow diagram showing an exemplary method for estimating one or more dynamic capacities of a battery for an electric vehicle, in accordance with some embodiments of present disclosure; and

**Figure 8** illustrates a block diagram of an exemplary computer system for implementing embodiments consistent with the present disclosure.

It should be appreciated by those skilled in the art that any block diagrams herein represent conceptual views of illustrative systems embodying the principles of the present subject matter. Similarly, it will be appreciated that any flow charts, flow diagrams, state transition diagrams, pseudo code, and the like represent various processes which may be substantially represented in computer readable medium and executed by a computer or processor, whether such computer or processor is explicitly shown.

## DETAILED DESCRIPTION

In the present document, the word "exemplary" is used herein to mean "serving as an example, instance, or illustration." Any embodiment or implementation of the present subject matter described herein as "exemplary" is not necessarily to be construed as preferred or advantageous over other embodiments.

While the disclosure is susceptible to various modifications and alternative forms, specific embodiment thereof has been shown by way of example in the drawings and will be described in detail below. It should be understood, however that it is not intended to limit the disclosure to the forms disclosed, but on the contrary, the disclosure is to cover all modifications, equivalents, and alternative falling within the spirit and the scope of the disclosure.

The terms "comprises", "comprising", or any other variations thereof, are intended to cover a nonexclusive inclusion, such that a setup, device, or method that comprises a list of components or steps does not include only those components or steps but may include other components or steps not expressly listed or inherent to such setup or device or method. In other words, one or more elements in a system or apparatus proceeded by "comprises... a" does not, without more constraints, preclude the existence of other elements or additional elements in the system or method.

The terms "includes", "including", or any other variations thereof, are intended to cover a nonexclusive inclusion, such that a setup, device, or method that includes a list of components or steps does not include only those components or steps but may include other components or steps not expressly listed or inherent to such setup or device or method. In other words, one or more elements in a system or apparatus proceeded by "includes... a" does not, without more constraints, preclude the existence of other elements or additional elements in the system or method.

In the following detailed description of the embodiments of the disclosure, reference is made to the accompanying drawings that form a part hereof, and in which are shown by way of illustration specific embodiments in which the disclosure may be practiced. These embodiments are described in sufficient detail to enable those skilled in the art to practice the disclosure, and it is to be understood that other embodiments may be utilized and that changes may be made without departing from the scope of the present disclosure. The following description is, therefore, not to be taken in a limiting sense.

Present disclosure relates to an estimation unit for estimating one or more dynamic capacities of a battery for an electric vehicle. The proposed unit is configured to receive state of health data of the battery of the electric vehicle. Upon receiving the state of health data, the proposed unit predicts one or more voltage profiles for one or more usages. The one or more dynamic capacities are estimated for the one or more usages using the one or more voltage profiles. Upon estimating the one or more dynamic capacities, longevity index and breakdown index of the battery is determined for the one or more usages using the estimated one or more dynamic capacities. By the proposed unit, the driver may overcome problem related to maintaining the battery of the electric vehicle and reduce overall cost of maintenance.

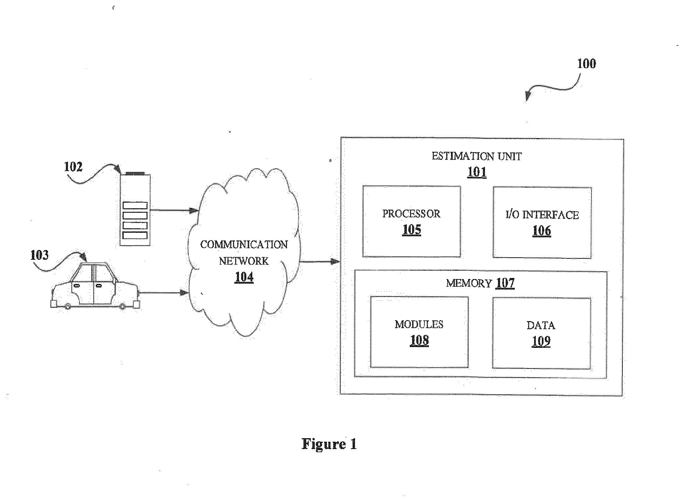

**Figure 1** shows an exemplary environment 100 of an estimation unit 101 for estimating one or more dynamic capacities of a battery for an electric vehicle. The exemplary environment 100 may include the estimation unit 101, a battery 102, an electric vehicle 103 and a communication network 104. The exemplary environment 100 may be interior of the electric vehicle 103 driven by a driver. The electric vehicle may be a car, cab, taxi, motorcycle, truck, bus and so on. The proposed estimation unit 101 may be implemented in any vehicle which may be an electric vehicle (103). In an embodiment, the electric vehicle 103 is a vehicle that uses battery system to run. In an embodiment, the estimation unit 101 may be implemented in a cloud-based server. In an embodiment, the estimation unit 101 may be implemented in Battery Energy Storage System (BESS). The BESS are rechargeable battery systems that could also be used to store electric energy from kinetic energy of the electric vehicle 103. For example, the electric vehicle 103 may be an electric car used for driving from a source point to destination point. The electric car may get stranded before reaching its destination point due to discharge of the battery 102. The estimation unit 101 may be used to prevent stranding of the electric vehicle 103 by providing range of distance that can be travelled by the electric vehicle 103. In an embodiment, range of distance of the electric vehicle 103 refers to a distance the electric vehicle 103 or hybrid vehicle may travel before the battery 102 needs to be recharged. The estimation unit 101 may be in communication with the battery 102 and the electric vehicle 103.

In an embodiment, the estimation unit 101 may communicate with the battery 102 and the electric vehicle 103 via the communication network 104. In an embodiment, the estimation unit 101 may communicate with each of the battery 102 and the electric vehicle 103 via respective dedicated communication network. In an embodiment, the communication network 104 may include, without limitation, a direct interconnection, Local Area Network (LAN), Wide Area Network (WAN), Controller Area Network (CAN), wireless network (e.g., using Wireless Application Protocol), the Internet, and the like.

Further, the estimation unit 101 may include a processor 105, I/O interface 106, and a memory 107. In some embodiments, the memory 107 may be communicatively coupled to the processor 105. The memory 107 stores instructions, executable by the processor 105, which, on execution, may cause the estimation unit 101 for estimating one or more dynamic capacities of the battery 102 for the electric vehicle 103, as disclosed in the present disclosure. In an embodiment, the memory 107 may include one or more modules 108 and data 109. The one or more modules 108 may be configured to perform the steps of the present disclosure using the data 109, for estimating one or more dynamic capacities of the battery 102 for the electric vehicle 103. In an embodiment, the one or more modules 108 may be configured to perform the steps of the present disclosure using the data 109, for determining longevity index of the battery 102 for the electric vehicle 103. In an embodiment, the one or more modules 108 may be configured to perform the steps of the present disclosure using the data 109, for predicting breakdown index of the battery 102 for the electric vehicle 103. In an embodiment, each of the one or more modules 108 may be a hardware unit which may be outside the memory 107. and coupled with the estimation unit 101. The estimation unit 101 may be implemented in a variety of computing systems, such as a laptop computer, a desktop computer, a Personal Computer (PC), a notebook, a smartphone, a tablet, e-book readers, a server, a network server, a cloud-based server and the like. In an embodiment, the estimation unit 101 may be a dedicated server implemented inside the electric vehicle 103.. In an embodiment, the estimation unit 101 may be associated with multiple electric vehicles through a cloud-based server. In such embodiment, the estimation unit 101 may communicate with each of the multiple electric vehicles to estimate one or more dynamic capacities of batteries in respective electric vehicles. In an embodiment, the I/O interface 106 is coupled with the at least one processor 105 through which an input signal or/and an output signal is communicated. The input signal and the output signal may represent data received by the estimation unit 101 and data transmitted by the estimation unit 101, respectively. In an embodiment of the present disclosure, the estimation unit 101 may be configured to receive and transmit data via the I/O interface 106. The received data may comprise future journey information, geo-location data, real-time battery data, and the like. The transmitted data may include the one or more dynamic capacities, the longevity index, the breakdown index and the like.

The estimation unit 101 may be configured to receive state of health data of the battery 102 of the electric vehicle 103. In an embodiment, the state of health data is a measurement that reflects general condition of the battery 102 and ability to deliver specified performance compared with a fresh battery. In an embodiment, the battery 102 may be an Electric Vehicle Battery (EVB) used to power electric motors of the electric vehicle 103 to run the electric vehicle 103. In an embodiment, the battery 102 may be integrated in the electric vehicle 103. In an embodiment, the battery 102 may be a detachable part of the electric vehicle 103. In an embodiment, the electric vehicle 103 is a vehicle that uses one or more electric motors for propulsion. Upon receiving the state of health data, the estimation unit 101 may be configured to predict one or more voltage profiles of the battery 102. In an embodiment, the one or more voltage profiles may be predicted for each of the one or more usages of the electric vehicle 103. The one or more usages may be including current usage of the electric vehicle 103, smoother usage of the electric vehicle 103 and aggressive usage of the electric vehicle 103. For example, the one or more usages of the electric vehicle 103 may depend on speed of driver. Consider that speed for the current usage of the electric vehicle 103 may be 50km/hr. Similarly, speed of the electric vehicle 103 for the smoother usage may be 40km/hr. Similarly, speed of the electric vehicle 103 for the aggressive usage may be 80km/hr. In an embodiment, the one or more usages of the electric vehicle 103 may also depend on factors such as driving habits, weather condition, seasons, road conditions and so on. For example, the driving habits may be of a driver of the electric vehicle 103, who may be a smooth driver or aggressive driver. In an embodiment, usage may be aggressive when the road condition is very bumpy with lots of potholes. In an embodiment, the one or more voltage profiles may be predicted based on at least one of the state of health data, geo-location data and the one or more load profiles of the battery 102. The geo-location data may be location of the electric vehicle 103 which may be provided by a Global Positioning System (GPS) associated with the electric vehicle 103. In an embodiment, the GPS may be integrated in the electric vehicle 103. Upon predicting the one or more voltage profiles, the estimation unit 101 may be configured to estimate the one or more dynamic capacities of the battery 102 for the one or more usages. In an embodiment, the one or more dynamic capacities is capacity of the battery 102 which may be extractable from the battery 102 for use or running of the electric vehicle 103. For example, generally capacity of the battery 102 that may be outputted corresponding to state of health of the battery 102. Consider according to the state of health of the battery 102, the capacity of the battery 102 that may be outputted may be 100%. However, actual capacity of the battery that may be outputted may be 90% due to internal resistance, loss of energy during charging of the battery 102, loss of energy during discharging of the battery 102, ageing of the battery 102, temperature of environment of the battery 102 and so on. Thus, the estimation unit 101 may be configured to estimate the actual capacity of the battery 102 that may be outputted.

In an embodiment, the state of health data comprises capacity state of health of the battery 102 and resistance state of health of the battery 102. The capacity state of health is a ratio of current capacity of the battery 102 to original rated capacity of the battery 102. The resistance state of health is a ratio between first difference and second difference. The first difference may be difference between current internal resistance of the battery 102 and end-of-life value of the battery 102. The second difference may be difference between original rated value of internal resistance to original rated end-of-life value of the battery 102. In an embodiment, the state of health data may be estimated using real-time data. The real-time data comprises current data, voltage data, temperature data and state of charge data related to the battery 102. Upon estimating the state of health data, the estimation unit 101 may be configured to predict ideal voltage profiles of the battery 102. The ideal voltage profiles may be predicted for the one or more usages of the electric vehicle 103. In an embodiment, the ideal voltage profiles may be predicted based on full Open Circuit Voltage (OCV) profiles, resistance behaviour of the battery 102, and a predefined discharge rate of the battery 102. In an embodiment, the estimation unit 101 may be configured to predict real-time voltage profile of the battery 102 for current usage of the electric vehicle 103. The real-time voltage profile may be predicted based on second OCV profile of the battery 102, resistance behaviour of the battery 102 and a predefined discharge rate of the battery 102. In an embodiment, the one or more voltage profiles may comprise the ideal voltage profiles and the real-time voltage profile of the battery 102. Upon predicting the one or more voltage profiles, the estimation unit 101 estimates the one or more dynamic capacities for the one or more usages. In an embodiment, the ideal voltage profiles and the real-time voltage profile may be compared to obtain value of voltage of the battery 102. The value of voltage may indicate a predefined lower limit of the voltage below which discharge of the battery 102 may be stopped.

In an embodiment, the estimation unit 101 may be configured to determine longevity index of the battery 102. The longevity index may be determined for the one or more usages based on the one or more dynamic capacities. In an embodiment, longevity index of the battery 102 may indicate lifespan of the battery 102. The lifespan of the battery 102 may be provided in terms of number of days. For example, consider that for the current usage of the electric vehicle 103, the longevity index may be 5 years. Similarly, longevity index of the electric vehicle 103 for the smoother usage may be 6 years. Similarly, longevity index of the electric vehicle 103 for the aggressive usage may be 4 years.

In an embodiment, the estimation unit 101 may be configured to predict breakdown index of the battery 102 for the one or more usages. The breakdown index may be determined for the one or more usages based on the one or more dynamic capacities and energy information. In an embodiment, the breakdown index of the electric vehicle 103 may indicate time at which the electric vehicle 103 may breakdown for the one or more usages. For example, consider that for the current usage of the electric vehicle 103, the breakdown may occur after travelling for 4 hours based on the one or more dynamic capacities of the battery 102. Similarly, breakdown of the electric vehicle 103 for the smoother usage may occur after travelling for 5 hours based on the one or more dynamic capacities of the battery 102. Similarly, breakdown of the electric vehicle 103 for the aggressive usage may occur after travelling for 3 hours based on the one or more dynamic capacities. Such information may be depicted from the breakdown index.

In an embodiment, the one or more dynamic capacities, the longevity index and the breakdown index for the one or more usages may be provided via a Human Machine Interface (HMI). The HMI may be a user interface or dashboard that connects a person to a machine, system, or device in the electric vehicle 103. In an embodiment, the HMI may include a display unit, a speaker, a microphone and so on. In an embodiment, the display unit may be used for displaying the one or more dynamic capacities, the longevity index and the breakdown index to driver or user. In an embodiment, speaker for providing audio alerts for breakdowns of the electric vehicle 103, which is identified using the breakdown index. In an embodiment, microphones could be used by drivers or user to provide voice commands to receive future journey information. to provide breakdown index for the electric vehicle 103. In an embodiment, the future journey information may include, but is not limited to, distance or length of the future journey, the geo-location related to the future journey, average velocity of the electric vehicle 103 through the future journey and so on.

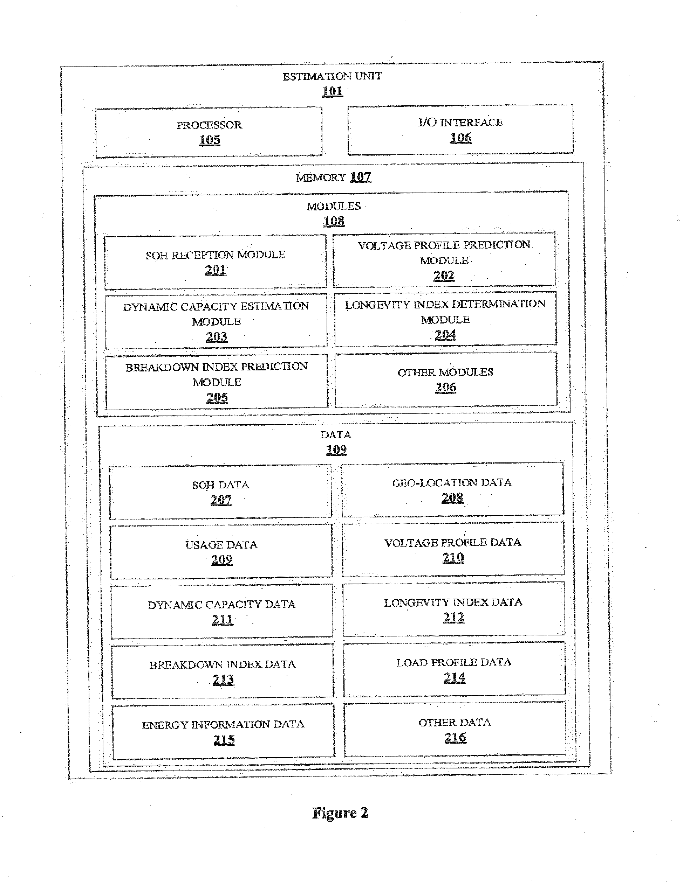

**Figure 2** shows a detailed block diagram of the estimation unit 101 for estimating one or more dynamic capacities of the battery 102 for the electric vehicle 103, in accordance with some embodiments of the present disclosure.

The data 109 and the one or more modules 108 in the memory 107 of the estimation unit 101 is described herein in detail.

In one implementation, the one or more modules 108 may include, but are not limited to, a SOH reception module 201, a voltage profile prediction module 202, a dynamic capacity estimation module 203, a longevity index determination module 204, a breakdown index prediction module 205, and one or more other modules 206, associated with the estimation unit 101.

In an embodiment, the data 109 in the memory 107 may include SOH data 207, geo-location data 208, usage data 209, voltage profile data 210, dynamic capacity data 211, longevity index data 212, breakdown index data 213, load profile data 214, energy information data 215, and other data 216 associated with the estimation unit 101.

In an embodiment, the data 109 in the memory 107 may be processed by the one or more modules 108 of the estimation unit 101. In an embodiment, the one or more modules 108 may be implemented as dedicated units and when implemented in such a manner, said modules may be configured with the functionality defined in the present disclosure to result in a novel hardware. As used herein, the term module may refer to an Application Specific Integrated Circuit (ASIC), an electronic circuit, a Field-Programmable Gate Arrays (FPGA), Programmable System-on-Chip (PSoC), a combinational logic circuit, and/or other suitable components that provide the described functionality.

One or more modules 108 of the estimation unit 101 function to not only estimate one or more dynamic capacities but also provides the longevity index and the breakdown index of the electric vehicle 103 for the one or more usages. The one or more modules 108 along with the data 109, may be implemented in any system, for estimating the one or more dynamic capacities of the electric vehicle 103.

In an embodiment, the estimation unit 101 comprises of the SOH reception module 201 that may be configured to receive the state of health data of the electric vehicle 103. In an embodiment, the state of health data is a measurement that reflects general condition of the battery 102 and ability to deliver specified performance compared with a fresh battery. In an embodiment, the state of health data may be referred as the SOH data 207 and stored in the memory 107. In an embodiment, the SOH data 207 comprises capacity state of health of the battery 102 and resistance state of health of the battery 102. The capacity state of health is a ratio of current capacity of the battery 102 to original rated capacity of the battery 102. The resistance state of health is a ratio between first difference and second difference. The first difference may be difference between current internal resistance of the battery 102 and end-of-life value of the battery 102. The second difference may be difference between original rated value of internal resistance to original rated end-of-life value of the battery 102. In an embodiment, the SOH data 207 may be based on battery pack model related to the battery 102. In an embodiment, the battery pack model may be a tool for obtaining the SOH data 207. The battery pack model may be periodically updated using real-time battery data. The real-time battery data may include, but is not limited to, current data, voltage data, temperature data and State Of Charge (SOC) data related to the battery 102. In an embodiment, the SOC of the battery 102 is a ratio of available capacity of the battery 102 and maximum possible charge that may be stored in the battery 102. In an embodiment, the real-time battery data may be collected from catalogue of the battery 102. In an embodiment, a regression based neural network may also be used to obtain the SOH data 207. Upon receiving the SOH data 207, the voltage profile prediction module 202 may be configured to predict the one or more voltage profiles of the battery 102. In an embodiment, the one or more voltage profiles may be predicted for the one or more usages. The one or more usages may include, but is not limited to, current usage of the electric vehicle 103, smoother usage of the electric vehicle 103 and aggressive usage of the electric vehicle 103. In an embodiment, the one or more usages may be referred as the usage data 209 and is stored in the memory 107. The one or more usages of the electric vehicle 103 may depend on speed of the electric vehicle 103, driving habits of the driver, weather condition, season, road conditions and so on. In an embodiment, the one or more voltage profiles of the battery 102 comprises ideal voltage profiles and real-time voltage profile. In an embodiment, the ideal voltage profile indicates voltage measured for corresponding usage from the one or more usages of the electric vehicle 103. In an embodiment, the one or more voltage profiles may be referred as the voltage profile data 210 and is stored in the memory 107.

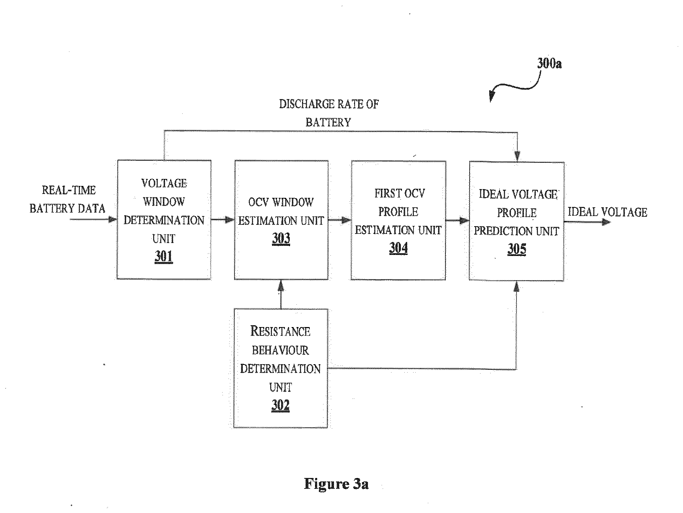

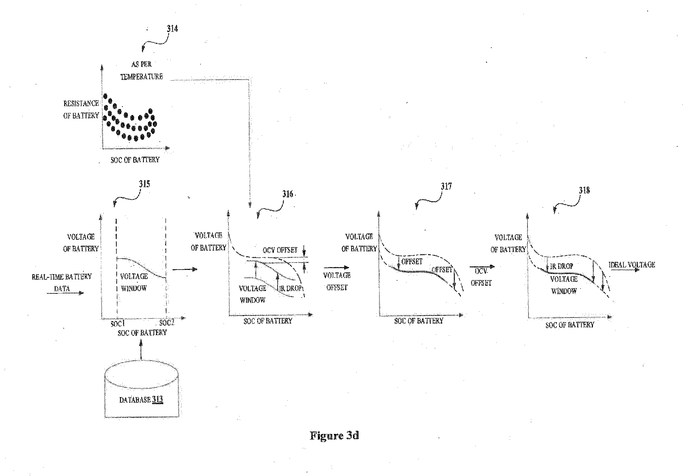

In an embodiment, **Figure 3a** shows a block diagram to predict the ideal voltage profile of the battery 102. In an embodiment, the voltage profile prediction module 202 for predicting the ideal voltage profiles comprises a voltage window determination unit 301, a resistance behaviour determination unit 302, an OCV window estimation unit 303, a first OCV profile estimation unit 304, and an ideal voltage profile prediction unit 305. In an embodiment, the voltage window determination unit 301 may be configured to determine voltage window of the battery 102 based on the SOH data 207 and measured load profile of the battery 102. In an embodiment, the voltage window of the battery 102 may be measured directly, if the voltage may be measurable, while the electric vehicle 103 is in operation. In an embodiment, the SOH data 207 may be obtained from the real-time battery data provided to the voltage window determination unit 301. The measured load profile may indicate value of current estimated for present route and velocity of the electric vehicle 103. For example, for the current usage of the electric vehicle 103, voltage of the battery 102 may be discharged between SOC1 and SOC2 of the battery 102. The voltage of the battery 102 is discharged based on the real-time battery data. The voltage discharge for the current usage indicates voltage window determined for the current usage as shown in plot 315 of **Figure 3d.** In an embodiment, the voltage window may be obtained from database 313 of **Figure 3d.** The database 313 may contain the voltage window of the electric vehicle 103 for the one or more usages.

Upon determining voltage window, the resistance behaviour determination unit 302 may be configured to determine resistance behaviour of the battery 102. The resistive behaviour of the battery 102 is determined by comparing the SOC of the battery 102 and the resistance state of health of the battery 102. Consider plot 314 for resistance behaviour of battery as shown in **Figure 3d.** The plot 314 of resistance behaviour of the battery 102 may be obtained as per temperature of environment. In an embodiment, if temperature of the environment is high, then resistance of the battery 102 may be less due to mobility of ions in the battery 102. Similarly, if temperature of the environment is low, then resistance of the battery 102 may be high due to lack of mobility of ions in the battery 102. Upon determining the resistance behaviour of the battery 102, the first OCV profile estimation unit 304 may be configured to estimate first Open Circuit Voltage (OCV) profiles. In an embodiment, OCV of the battery 102 is a voltage in which the battery 102 is not connected to any load in a circuit. The first OCV profiles may be estimated for each of the one or more usages based on OCV window. In an embodiment, the OCV window estimation unit 303 may be configured to estimate the OCV window. The OCV window may be estimated from the determined voltage window for the current usage. The estimated OCV window may not be coinciding with the determined voltage window due to IR drop. The IR drop may be obtained due to internal resistance of the battery 102. Plot 316 in **Figure 3d** shows the OCV window. The dashed line in plot 316 shows actual OCV of the battery 102 which may be obtained from manufacturer or by performing an experiment to determine the OCV. In an embodiment, the experiment may include, but is not limited to, low-current OCV test. The low-current OCV test uses small amount of current to charge and discharge the battery 102 and measures output voltage which may be approximately equal to the actual OCV. In an embodiment, the first OCV profile estimation unit 304 may be configured to obtain offset value. The offset value may be difference between the actual OCV of the battery 102 and the estimated first OCV profiles of the battery 102. Upon obtaining the offset value, the first OCV profile estimation unit 304 may be configured to estimate full OCV profile for the current usage of the electric vehicle 103 using the actual OCV profile. Exemplary representation of first OCV profile is shown as plot 317 in **Figure 3d.** The offset value may be used to recreate the full OCV profile for the first OCV profile using the actual OCV profile of the battery 102. Upon estimating the full OCV profile using the estimated first OCV profile, the ideal voltage profile prediction unit 305 may be configured to predict the ideal voltage profile for the current usage of the electric vehicle 103. In an embodiment, the ideal voltage profile may be based on the full OCV profile, the resistance behaviour, and a predefined discharge rate of the battery .J 02. In an embodiment, a discharge rate of the battery 102 may be steady current in amperes which may be taken from the battery 102 of defined capacity over a defined period.

For example, the predefined discharge rate of the battery 102 may be 20 amperes per hour. Exemplary representation of the ideal voltage profile is shown as plot 318 in **Figure 3d.** The ideal voltage profile may be predicted by recreating full voltage window of the battery 102 by using the full OCV profile.

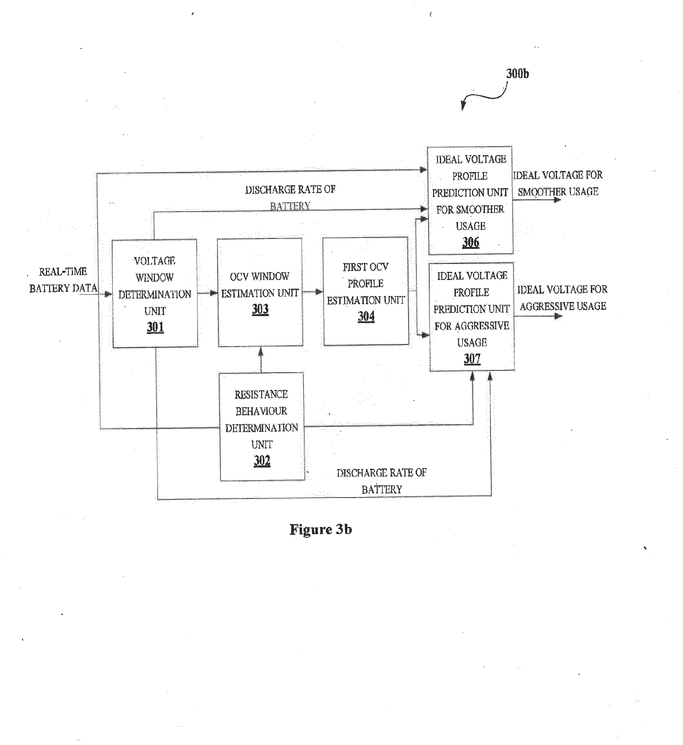

In an embodiment, the voltage profile prediction module 202 may be configured to perform steps indicated in **Figures 3b and 3d** to predict the ideal voltage profiles for the smoother usage and for the aggressive usage. The voltage window for smoother usage may be considered for predicting the ideal voltage profile for the smoother usage. The voltage window for aggressive usage may be considered for predicting the ideal voltage profile for the aggressive usage. In an embodiment, the voltage profile prediction module 202 for predicting the ideal voltage profiles for the smoother usage and the aggressive usage comprises the voltage window determination unit 301, the resistance behaviour determination unit 302, the OCV window estimation unit 303, the first OCV profile estimation unit 304, an ideal voltage profile prediction unit 306 for the smoother usage, and 6an ideal voltage profile prediction unit 307 for the aggressive usage. In an embodiment, the voltage window determination unit 301 may be configured to determine voltage window of the battery 102 based on the SOH data 207 and the measured load profile of the battery 102 for the smoother usage. Similarly, the voltage window determination unit 301 determines voltage window of the battery 102 for the aggressive usage. In an embodiment, the SOH data 207 may be obtained from the real-time battery data provided to the voltage window determination unit 301. In an embodiment, exemplary representation of the voltage window determined for the smoother usage of the electric vehicle 103 may be plot 315 as shown in **Figure 3d.** Exemplary representation of the voltage window determined for the aggressive usage of the electric vehicle 103 may be similar to the plot 315 of **Figure 3d** with values of voltage measures for the aggressive usage. Upon determining the voltage window, the resistance behaviour determination unit 302 may be configured to determine resistance behaviour of the battery 102. In an embodiment, the plot 314 of **Figure 3d** shows the resistance behaviour of battery 102. Upon determining the resistance behaviour of the battery 102, the first OCV profile estimation unit 304 may be configured to estimate the first OCV profiles for the smoother usage and the aggressive usage of the electric vehicle 103. The first OCV profiles may be estimated based on the OCV window. In an embodiment, the OCV window estimation unit 303 may be configured to estimate the OCV window for the smoother usage and the aggressive usage of the electric vehicle 103. In an embodiment, the OCV window for the smoother usage and the aggressive usage may be similar to the plot 316 of **Figure 3d.** In an embodiment, the first OCV profiles for the smoother usage and the aggressive usage may be similar to the plot 317 of **Figure 3d.** In an embodiment, the ideal voltage profile prediction unit 306 for smoother usage may be configured to predict the ideal voltage profile for the smoother usage of the electric vehicle 103. Similarly, the ideal voltage profile prediction unit 307 for aggressive usage may be configured to predict the ideal voltage profile for the aggressive usage of the electric vehicle 103. In an embodiment, the ideal voltage profile for the smoother usage and the aggressive usage may be similar to the plot 318 of **Figure 3d.**

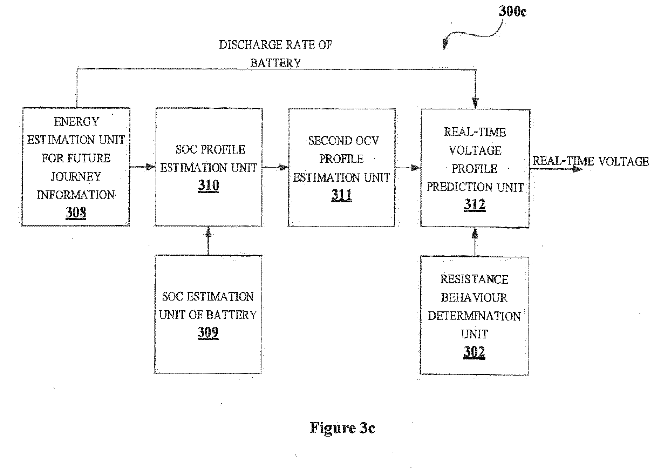

In an embodiment, **Figure 3c** shows a block diagram to predict the real-time voltage profile of the battery 102. In an embodiment, the voltage profile prediction module 202 for predicting the real-time voltage profile comprises an energy estimation unit 308 for future journey information, a SOC estimation unit 309 of battery, a SOC profile estimation unit 310, a second OCV profile estimation unit 311, the resistance behaviour determination unit 302, and a real-time voltage profile prediction unit 312. In an embodiment, the real-time voltage profile indicates voltage determined for the current usage of the electric vehicle 103. The energy estimation unit 308 for future journey information of **Figure 3c** may be configured to estimate amount of energy required to travel for future journey of the electric vehicle 103. For example, the electric vehicle 103 may travel from a source point to a destination point which may be referred as the future journey of the electric vehicle 103. In an embodiment, information about the future journey of the electric vehicle 103 may be obtained from driver of the electric vehicle 103 via the HMI. Upon providing energy required for the future journey, the SOC profile estimation unit 310 may be configured to determine SOC profile of the battery 102. In an embodiment, the energy required for the future journey and start SOC of the battery 102 may be used to determine the SOC profile. In an embodiment, the SOC estimation unit 309 of the battery 102 may be configured to estimate the start SOC of the battery 102. In an embodiment, the SOC profile may be end SOC of the battery 102 and may be calculated using equation 1 as shown below:

$$\text{End SOC of battery} = \frac{\text{Start SOC of battery} + \text{Required energy for future journey}}{\text{Maximum rate capacity of battery} * \text{Capacity state of health of battery}}$$

.......... (1)

In an embodiment, upon determining the SOC profile, the second OCV profile estimation unit 311 may be configured to estimate second OCV profile of the battery 102. In an embodiment, the second OCV profile may be estimated based on the SOC profile and predicted load profile. The predicted load profile indicates values of current estimated for the geo-location data 208, future journey and velocity of the electric vehicle 103. In an embodiment, the geo-location data 208 may be location of the electric vehicle 103 obtained via the GPS. The location of the electric vehicle 103 may be referred as the geo-location data 208 and is stored in the memory 107. In an embodiment, the future journey of the electric vehicle 103 may be path or direction from a source point to a destination point. In an embodiment, the velocity of the electric vehicle 103 may be speed of the electric vehicle 103 on route of the future journey obtained from Map Application Programming Interface (Map API). The Map API (also known as mapping API) provides location and velocity intelligence information relating to the electric vehicle 103. In an embodiment, the second OCV profile may be estimated using steps indicated in **Figure 3d.** Upon estimating the second OCV profile, the real-time voltage profile prediction unit 312 may be configured to predict the real-time voltage profile of the battery 102 for the current usage of the electric vehicle 103. The real-time voltage profile may be predicted based on the second OCV profile, the resistance behaviour of the battery 102 and the predefined discharge rate of the battery 102.

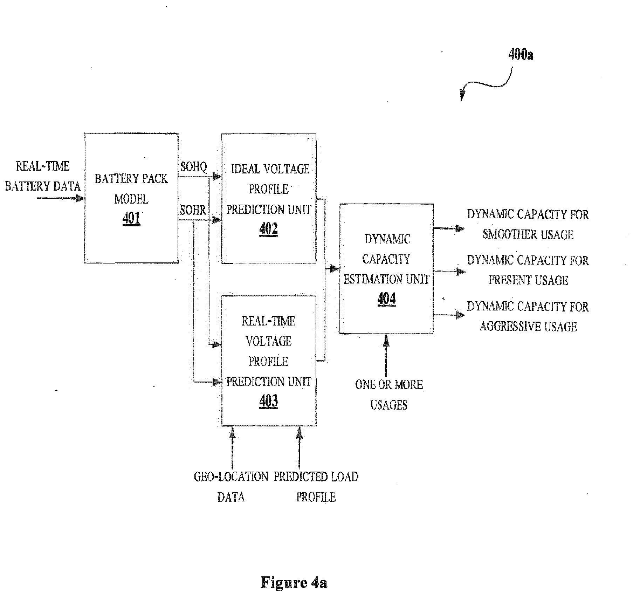

In an embodiment, upon predicting the one or more voltage profiles, the dynamic capacity estimation module 203 may be configured to estimate one or more dynamic capacities of the battery 102. The one or more dynamic capacities may be energy that may be extractable from the battery 102 for usages. In an embodiment, the one or more dynamic capacities may be estimated for the one or more usages. In an embodiment, the real-time data may be provided to the battery pack model 401 to obtain the capacity state of health of the battery 102 and the resistance state of the health of the battery 102 as shown in **Figure 4a.** In an embodiment, the capacity state of health of the battery 102 is referred as SOHQ as shown in **Figure 4a.** In an embodiment, the resistance state of health of the battery 102 is referred as SOHR as shown in **Figure 4a.**

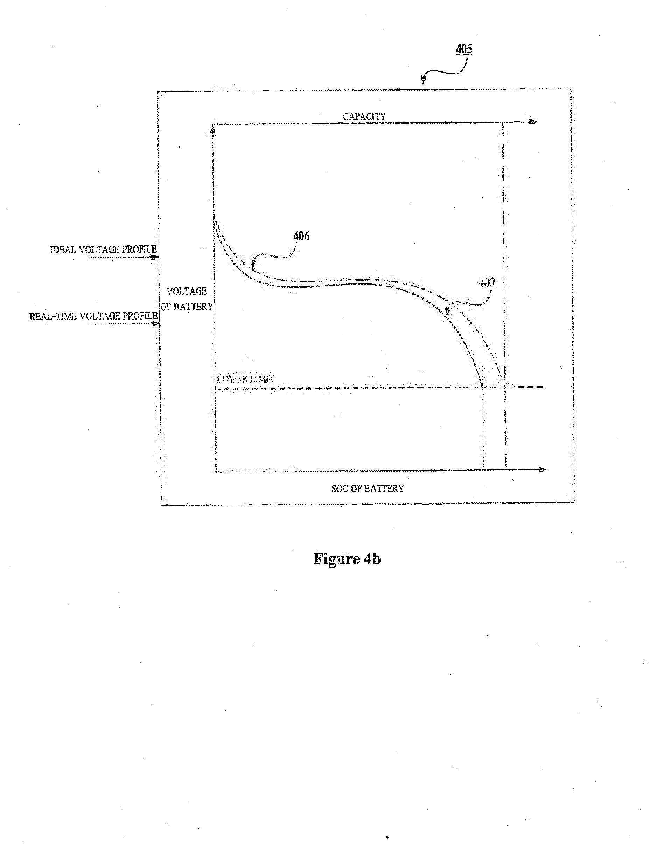

In an embodiment, the SOHQ and the SOHR is provided for prediction of ideal voltage profiles. In an embodiment, the ideal voltage profile prediction unit 402 may be configured to predict the ideal voltage profiles. In an embodiment, the SOHQ and the SOHR along with the geo-location data 208 and the predicted load profile is provided for prediction of the real-time voltage profile. In an embodiment, the real-time voltage profile prediction unit 403 may be configured to predict the real-time voltage profile. In an embodiment, the ideal voltage profile and the real-time voltage profile may be provided for estimation of dynamic capacity of the current usage of the electric vehicle 103. In an embodiment, the dynamic capacity estimation unit 404 for one or more usages may be configured to estimate the one or more dynamic capacities for the one or more usages of the electric vehicle 103. The one or more dynamic capacities for the one or more usages may include dynamic capacity for the smoother usage, dynamic capacity for the current or present usage and dynamic capacity for the aggressive usage. Consider **Figure 4b** to estimate the dynamic capacity for the current or present usage of the electric vehicle 103. In an embodiment, the ideal voltage profile and the real-time voltage profile may be compared to obtain a value of voltage of the battery 102. Ideally, the value of voltage may drop to reach a predefined lower limit of voltage of the battery 102. In an embodiment, the predefined lower limit of voltage of the battery 102 indicates a voltage value for which Battery Management System (BMS) stops discharging of the battery 102. The BMS is any electronic system that manages a rechargeable battery by protecting the battery from operating outside its safe operating area or the predefined lower limit.

Upon comparing, the dynamic capacity estimation unit 404 may be configured to identify total capacity discharged by the battery 102. In an embodiment, the total capacity discharged may be amount of energy which may be drawn from the battery 102. Upon identifying the total capacity discharged, the dynamic capacity estimation unit 404 may be configured to compare the total capacity discharged for corresponding usage with the capacity state of health of the battery 102. Further upon comparison, dynamic capacity of the battery 102 for the current usage may be determined. Line 407 in plot 405 of **Figure 4b** shows the dynamic capacity of the battery 102 for the current usage which may be less than dynamic capacity of the battery 102 in ideal condition as shown as line 406 in the plot 405 of **Figure 4b.** In an embodiment, the ideal condition may include, but is not limited to, no internal resistance in the battery 102, ideal environment condition which is between 20 degree Celsius to 60 degree Celsius and so on. Similarly, the dynamic capacity of the battery 102 for the smoother usage may be more than the dynamic capacity of the current usage and less than or equal to the dynamic capacity of the battery 102 in the ideal condition. Similarly, the dynamic capacity of the battery 102 for the aggressive usage may be less than the dynamic capacity of the current usage and the smoother usage, and much lesser than the dynamic capacity of the battery 102 in the ideal condition. In an embodiment, the dynamic capacity for the one or more usages may be referred as the dynamic capacity data 211 and stored in the memory 107.

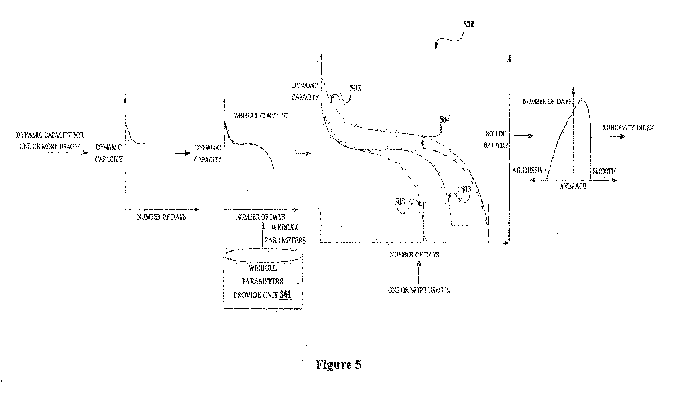

In an embodiment, upon estimating the dynamic capacity for the one or more usages, the longevity index determination module 204 may be configured to determine longevity index of the battery 102. In an embodiment, the longevity index may be determined for the one or more usages. The longevity of the battery 102 is lifespan of the battery 102 in terms of number of days or energy throughput. In an embodiment, the energy throughput may be total amount of energy the battery 102 may be expected to store and deliver over its lifespan. Consider **Figure 5** to determine the longevity index for the one or more usages. In an embodiment, the dynamic capacity estimated over the energy throughput increases for the smoother usage. In an embodiment, the dynamic capacity estimated over the energy throughput may be less for the current usage. In an embodiment, the dynamic capacity estimated over the energy throughput may be least for the aggressive usage. For example, consider for the current usage of the electric vehicle 103, the dynamic capacity may be fitted using a Weibull distribution curve using Weibull parameters obtained from Weibull parameters provide unit 501. Weibull distribution is a continuous probability distribution and is used to assess product reliability, analyze life data and times of model failure. In an embodiment, Weibull parameters may include, but is not limited to, two parameter Weibull and three parameter Weibull. The two parameter Weibull may be often used in failure analysis. The three parameter Weibull may be used for describing shape, scale and threshold parameters of a product. In an embodiment, Weibull degradation function may be given by equation 2.

$$\text{Degradation} = \exp\left[-\left(\frac{t}{\tau}\right)^{n}\right] \dots\dots\dots (2)$$

where, t = degradation time constant; and
n = index of degradation which is less than or equal to 1

In an embodiment, dynamic capacity degradation may be estimated based on the Weibull distribution curves for the one or more usages. In an embodiment, lower limit of dynamic capacity may be pre-decided based on the current or present usage of the electric vehicle 103. In an embodiment, total energy throughput for each of the one or more usages may be observed and as per daily usage the longevity index may be determined. For example, consider dashed line 502 in plot 500 of **Figure 5.** The dashed line 502 shows maximum longevity of the battery 102 in the ideal condition. Similarly, solid line 503 in the plot 500 of **Figure 5** shows the longevity of the battery 102 for the current usage of the electric vehicle 103, which is less than the longevity of the battery 102 in the ideal condition. Similarly, dashed line 504 in the plot 500 of **Figure 5,** shows the longevity of the battery 102 for the smoother usage of the electric vehicle 103, which is almost equal to the longevity of the battery 102 in the ideal condition. Similarly, dashed line 505 in the plot 500 of **Figure 5** shows the longevity of the battery 102 for the aggressive usage of the electric vehicle 103, which is very less compared to the longevity of the battery 102 in the ideal condition. For example, the longevity of the battery 102 for the current usage may be 5 years. Similarly, the longevity of the battery 102 for the smoother usage may be 6 years. Similarly, the longevity of the battery 102 for the aggressive usage may be 4 years. In an embodiment, the longevity of the battery 102 for the one or more usages may be referred as the longevity index data 212 and is stored in the memory 107.

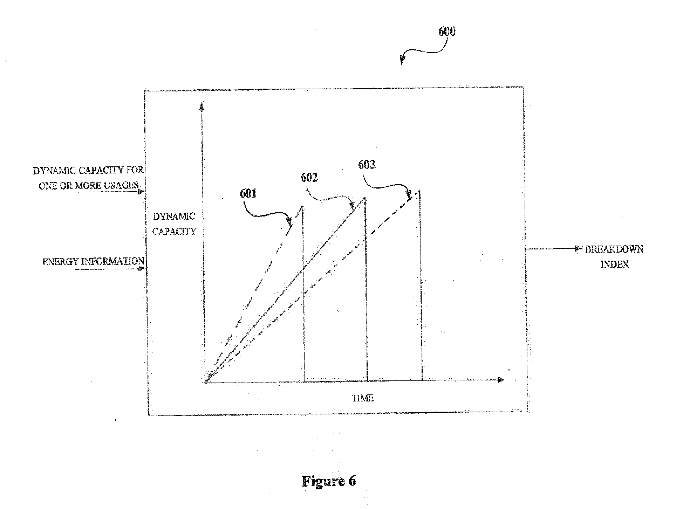

In an embodiment, upon estimating the one or more dynamic capacities for the one or more usages, the breakdown index prediction module 205 may be configured to predict breakdown index of the battery 102. In an embodiment, the breakdown index may be predicted for the one or more usages based on the one or more dynamic capacities and energy information. In an embodiment, the energy information may include, but is not limited to, driver behaviour, the geo-location data 208, velocity of the electric vehicle 103, length of the future journey and so on. In an embodiment, the driver behaviour may indicate driving pattern of the driver for the electric vehicle 103. In an embodiment, velocity of the electric vehicle 103 may be average road velocity and may be obtained from the map API. In an embodiment, the energy information related to the driver and the electric vehicle 103 may be referred as the energy information data 215 and is stored in the memory 107. In an embodiment, the breakdown index prediction module 205 may be configured to predict energy and rate of the energy that may be required from the battery 102 with respect to the future journey information. The future journey information may be information about length of the future journey and location of the source point and the destination point. Upon predicting the required energy and the rate of the energy, the breakdown index prediction module 205 may be configured to predict the breakdown index for each of the one or more usages. The breakdown index of the electric vehicle 103 may be predicted in terms of time as shown in **Figure 6.** For example, for the future journey information, the electric vehicle 103 for the current or average usage may breakdown around 5 hours after travelling. Similarly, for the same future journey information, the electric vehicle 103 for the smoother usage may breakdown around 6 hours after travelling. Similarly, for the same future journey information, the electric vehicle 103 for the aggressive usage may breakdown around 4 hours after travelling. In an embodiment, dashed line 601 in plot 600 of **Figure 6** shows breakdown for the aggressive usage of the electric vehicle 103. In an embodiment, solid line 602 in the plot 600 of **Figure 6** shows breakdown for the current or average usage of the electric vehicle 103. In an embodiment, dashed line 603 in plot 600 of **Figure 6** shows breakdown for the smoother usage of the electric vehicle 103. In an embodiment, the breakdown index predicted for the one or more usages may be referred as the breakdown index data 213 and stored in the memory 107.

The other data 216 may store data, including temporary data and temporary files, generated by modules for performing the various functions of the estimation unit 101. The one or more modules 108 may also include other modules 206 to perform various miscellaneous functionalities of the estimation unit 101. It will be appreciated that such modules may be represented as a single module or a combination of different modules.

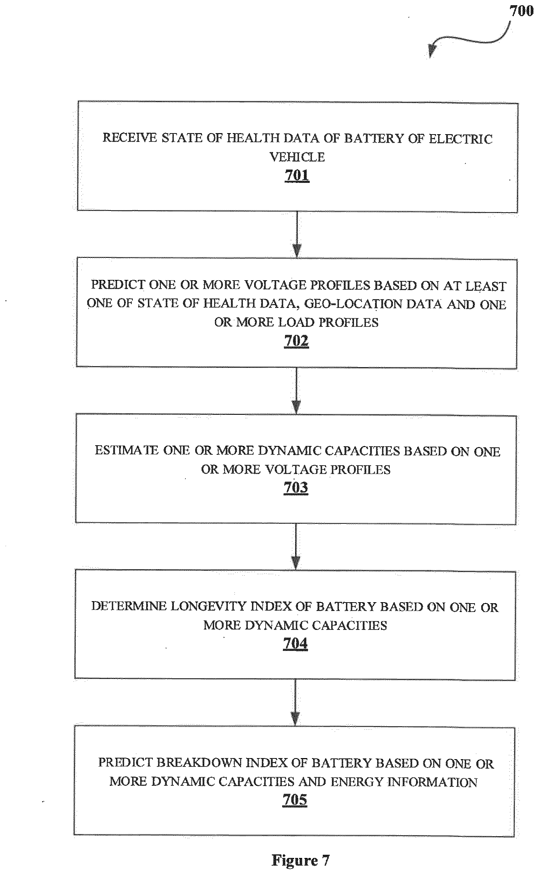

**Figure 7** illustrates a flow diagram showing an exemplary method for estimating the one or more dynamic capacities of the battery 102 for the electric vehicle 103, in accordance with some embodiments of present disclosure.

At block 701, the SOH reception module 201 may be configured to receive the SOH data 207. In an embodiment, the SOH data 207 includes the capacity state of health of the battery 102 and the resistance state of health of the battery 102. In an embodiment, the SOH data 207 may be based on the real-time battery data. In an embodiment, the real-time battery data may be collected from catalogue of the battery 102 of the electric vehicle 103. The real-time battery data comprises the current data, the voltage data, the temperature data and the SOC data related to the battery 102 of the electric vehicle 103. In an embodiment, the SOH reception module 201 may be configured to determine the SOH data 207 using the battery pack model 401. In an embodiment, the SOH data 207 may be determined using machine learning methods such as neural network, support vector regression, fuzzy logic and so on.

At block 702, upon receiving the SOH data 207, the voltage profile prediction module 202 may be configured to predict the one or more voltage profiles of the battery 102. In an embodiment, the one or more voltage profiles comprises the ideal voltage profiles and the real-time voltage profile. In an embodiment, the ideal voltage profiles may be predicted using the capacity state of health data, the resistance state of health data and the load profile data 214. In an embodiment, the real-time voltage profile may be predicted using the SOH data 207, the geo-location data 208 of the electric vehicle 103, the load profile data 214 of the battery 102.

At block 703, upon predicting the one or more voltage profiles, the dynamic capacity estimation module 203 may be configured to estimate the one or mor dynamic capacities of the battery 102. In an embodiment, the one or more dynamic capacities may be estimated for the one or more usages. In an embodiment, the one or more dynamic capacities may be the capacity or energy that is extractable from the battery 102 for the one or more usages. For example, consider the dynamic capacity that may be extractable from the battery 102 for the current usage may be 80%. Similarly, the dynamic capacity that may be extractable from the battery 102 for the smoother usage may be 90%. Similarly, the dynamic capacity that may be extractable from the battery 102 for the aggressive usage may be 70%.

At block 704, upon estimating the one or more dynamic capacities, the longevity index determination module 204 may be configured to determine the longevity index of the battery 102. In an embodiment, the longevity index may be determined for the one or more usages. In an embodiment, the longevity index may be determined using the Weibull curve. In an embodiment, the longevity index may be provided in terms of number of days or the energy throughput as required by user or driver of the electric vehicle 103. In an embodiment, one or more other techniques, known to a person skilled in art, may be implemented to determine the longevity index using the one or more dynamic capacities. In an embodiment, the one or more other techniques which may be used to determine the longevity index of the battery 102 may include, but are not limited to, Artificial Intelligence (AI) model, surface fit, look-up table obtained based on historic data of the electric vehicle 103 and so on.

At block 705, upon estimating the one or more dynamic capacities, the breakdown index prediction module 205 may be configured to predict the breakdown index of the electric vehicle 103. In an embodiment, the breakdown index may be predicted for the one or more usages. In an embodiment, to predict the breakdown index, the other modules 206 may be configured to calculate the energy information data 215. The energy information data 215 comprises energy and rate of the energy required from the battery 102 with respect to the future journey information of the electric vehicle 103. In an embodiment, the future journey information may be provided by the user or driver of the electric vehicle 103 via the HMI. The future journey information may include length or duration of the future journey, the driver behaviour, the geo-location of the electric vehicle 103, the average velocity on road.

As illustrated in **Figure 7,** the method 700 may include one or more blocks for executing processes in the estimation unit 101. The method 700 may be described in the general context of computer executable instructions. Generally, computer executable instructions can include routines, programs, objects, components, data structures, procedures, modules, and functions, which perform particular functions or implement particular abstract data types.

The order in which the method 700 is described may not intended to be construed as a limitation, and any number of the described method blocks can be combined in any order to implement the method. Additionally, individual blocks may be deleted from the methods without departing from the scope of the subject matter described herein. Furthermore, the method can be implemented in any suitable hardware, software, firmware, or combination thereof.

Computing System

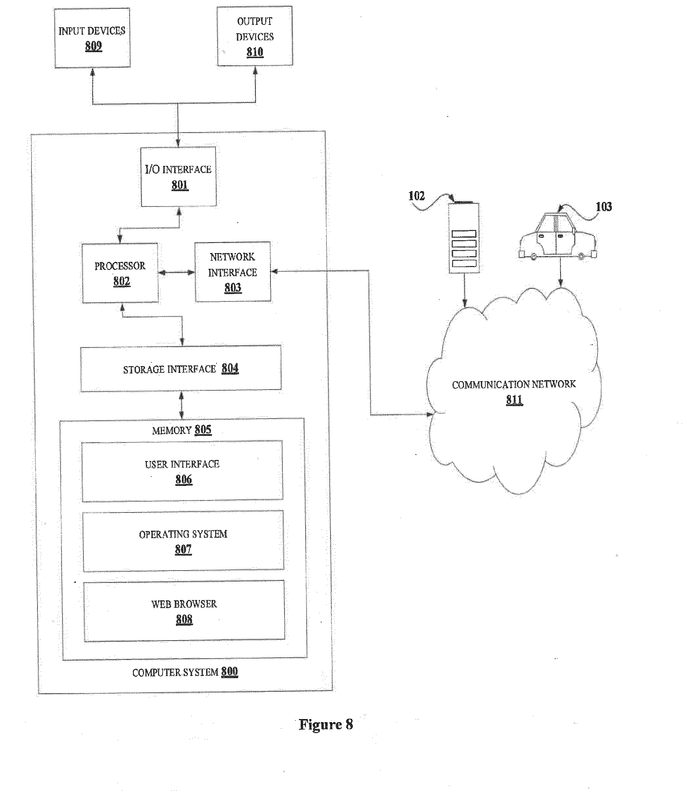

**Figure 8** illustrates a block diagram of an exemplary computer system 800 for implementing embodiments consistent with the present disclosure. In an embodiment, the computer system 800 is used to implement the estimation unit 101. The computer system 800 may include a central processing unit ("CPU" or "processor") 802. In an embodiment, the processor 802 bears the processor 105. The processor 802 may include at least one data processor for executing processes in Virtual Storage Area Network. The processor 802 may include specialized processing units such as, integrated system (bus) controllers, memory management control units, floating point units, graphics processing units, digital signal processing units, etc.

The processor 802 may be disposed in communication with one or more input/output (I/O) devices 809 and 810 via I/O interface 801. The I/O interface 801 may employ communication protocols/methods such as, without limitation, audio, analog, digital, monaural, RCA, stereo, IEEE-1394, serial bus, universal serial bus (USB), infrared, PS/2, BNC, coaxial, component, composite, digital visual interface (DVI), high-definition multimedia interface (HDMI), RF antennas, S-Video, VGA, IEEE 802.n /b/g/n/x, Bluetooth, cellular (e.g., code-division multiple access (CDMA), high-speed packet access (HSPA+), global system for mobile communications (GSM), long-term evolution (LTE), WiMax, or the like), etc.

Using the I/O interface 801, the computer system 800 may communicate with one or more I/O devices 809 and 810. For example, the input devices 809 may be an antenna, keyboard, mouse, joystick, (infrared) remote control, camera, card reader, fax machine, dongle, biometric reader, microphone, touch screen, touchpad, trackball, stylus, scanner, storage device, transceiver, video device/source, etc. The output devices 810 may be a printer, fax machine, video display (e.g., cathode ray tube (CRT), liquid crystal display (LCD), light-emitting diode (LED), plasma, Plasma display panel (PDP), Organic light-emitting diode display (OLED) or the like), audio speaker, etc.

In some embodiments, the computer system 800 may consist of the estimation unit 101. The processor 802 may be disposed in communication with the communication network 811 via a network interface 803. The network interface 803 may communicate with the communication network 811. The network interface 803 may employ connection protocols including, without limitation, direct connect, Ethernet (e.g., twisted pair 10/100/1000 Base T), transmission control protocol/internet protocol (TCP/IP), token ring, IEEE 802.11a/b/g/n/x, etc. The communication network 811 may include, without limitation, a direct interconnection, local area network (LAN), wide area network (WAN), wireless network (e.g., using Wireless Application Protocol), the Internet, etc. Using the network interface 803 and the communication network 811, the computer system 800 may communicate with the battery 102 and the electric vehicle 103 for estimating one or more dynamic capacities of the battery 102 for the electric vehicle 103, for one or more usages of the electric vehicle 103. The network interface 803 may employ connection protocols include, but not limited to, direct connect, Ethernet (e.g., twisted pair 10/100/1000 Base T), transmission control protocol/internet protocol (TCP/IP), token ring, IEEE 802.11a/b/g/n/x, etc.

The communication network 811 includes, but is not limited to, a direct interconnection, an e-commerce network, a peer to peer (P2P) network, local area network (LAN), wide area network (WAN), wireless network (e.g., using Wireless Application Protocol), the Internet, Wi-Fi, and such. The first network and the second network may either be a dedicated network or a shared network, which represents an association of the different types of networks that use a variety of protocols, for example, Hypertext Transfer Protocol (HTTP), Transmission Control Protocol/Internet Protocol (TCP/IP), Wireless Application Protocol (WAP), etc., to communicate with each other. Further, the first network and the second network may include a variety of network devices, including routers, bridges, servers, computing devices, storage devices, etc.

In some embodiments, the processor 802 may be disposed in communication with a memory 805 (e.g., RAM, ROM, etc. not shown in **Figure 8**) via a storage interface 804. In an embodiment, the memory 805 bears the memory 107. The storage interface 804 may connect to memory 805 including, without limitation, memory drives, removable disc drives, etc., employing connection protocols such as, serial advanced technology attachment (SATA), Integrated Drive Electronics (IDE), IEEE-1394, Universal Serial Bus (USB), fibre channel, Small Computer Systems Interface (SCSI), etc. The memory drives may further include a drum, magnetic disc drive, magneto-optical drive, optical drive, Redundant Array of Independent Discs (RAID), solid-state memory devices, solid-state drives, etc.

The memory 805 may store a collection of program or database components, including, without limitation, user interface 806, an operating system 807 etc. In some embodiments, computer system 800 may store user/application data, such as, the data, variables, records, etc., as described in this disclosure. Such databases may be implemented as fault-tolerant, relational, scalable, secure databases such as Oracle ® or Sybase®.

The operating system 807 may facilitate resource management and operation of the computer system 800. Examples of operating systems include, without limitation, APPLE MACINTOSH® OS X, UNIX®, UNIX-like system distributions (E.G., BERKELEY SOFTWARE DISTRIBUTION™ (BSD), FREEBSD™, NETBSD™, .OPENBSD™, etc.), LINUX DISTRIBUTIONS™ (E.G., RED HAT™, UBUNTU™, KUBUNTU™, etc.), IBM™ OS/2, MICROSOFT™ WINDOWS™ (XP™, VISTA™/7/8, 10 etc.), APPLE® IOS™, GOOGLE® ANDROID™, BLACKBERRY® OS, or the like.

In some embodiments, the computer system 800 may implement a web browser 808 stored program component. The web browser 808 may be a hypertext viewing application, such as Microsoft Internet Explorer, Google Chrome, Mozilla Firefox, Apple Safari, etc. Secure web browsing may be provided using Hypertext Transport Protocol Secure (HTTPS), Secure Sockets Layer (SSL), Transport Layer Security (TLS), etc. Web browser 808 may utilize facilities such as AJAX, DHTML, Adobe Flash, JavaScript, Java, Application Programming Interfaces (APIs), etc. In some embodiments, the computer system 800 may implement a mail server stored program component. The mail server may be an Internet mail server such as Microsoft Exchange, or the like. The mail server may utilize facilities such as ASP, ActiveX, ANSI C++/C#, Microsoft .NET, Common Gateway Interface (CGI) scripts, Java, JavaScript, PERL, PHP, Python, WebObjects, etc. The mail server may utilize communication protocols such as Internet Message Access Protocol (IMAP), Messaging Application Programming Interface (MAPI), Microsoft Exchange, Post Office Protocol (POP), Simple Mail Transfer Protocol (SMTP), or the like. In some embodiments, the computer system 800 may implement a mail client stored program component. The mail client may be a mail viewing application, such as Apple Mail, Microsoft Entourage, Microsoft Outlook, Mozilla Thunderbird, etc.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include Random Access Memory (RAM), Read-Only Memory (ROM), volatile memory, non-volatile memory, hard drives, CD ROMs, DVDs, flash drives, disks, and any other known physical storage media.

### Advantages

An embodiment of the present disclosure provisions a method for determining longevity index of a battery for one or more usages by estimating one or more dynamic capacities of the battery for an electric vehicle.

An embodiment of the present disclosure provisions to avoid stranding of the electric vehicle on road by predicting breakdown index of the battery for the electric vehicle by estimating one or more dynamic capacities.

An embodiment of the present disclosure avoids fire hazards by efficiently maintaining the electric vehicle by estimating the dynamic capacity of the battery of the electric vehicle.

The described operations may be implemented as a method, system or article of manufacture using standard programming and/or engineering techniques to produce software, firmware, hardware, or any combination thereof. The described operations may be implemented as code maintained in a "non-transitory computer readable medium", where a processor may read and execute the code from the computer readable medium. The processor is at least one of a microprocessor and a processor capable of processing and executing the queries. A non-transitory computer readable medium may include media such as magnetic storage medium (e.g., hard disk drives, floppy disks, tape, etc.), optical storage (CD-ROMs, DVDs, optical disks, etc.), volatile and non-volatile memory devices (e.g., EEPROMs, ROMs, PROMs, RAMs, DRAMs, SRAMs, Flash Memory, firmware, programmable logic, etc.), etc. Further, non-transitory computer-readable media may include all computer-readable media except for a transitory. The code implementing the described operations may further be implemented in hardware logic (e.g., an integrated circuit chip, Programmable Gate Array (PGA), Application Specific Integrated Circuit (ASIC), etc.).

An "article of manufacture" includes non-transitory computer readable medium, and /or hardware logic, in which code may be implemented. A device in which the code implementing the described embodiments of operations is encoded may include a computer readable medium or hardware logic. Of course, those skilled in the art will recognize that many modifications may be made to this configuration without departing from the scope of the invention, and that the article of manufacture may include suitable information bearing medium known in the art.

The terms "an embodiment", "embodiment", "embodiments", "the embodiment", "the embodiments", "one or more embodiments", "some embodiments", and "one embodiment" mean "one or more (but not all) embodiments of the invention(s)" unless expressly specified otherwise.

The terms ."including", "comprising", "having" and variations thereof mean "including but not limited to", unless expressly specified otherwise.

The enumerated listing of items does not imply that any or all of the items are mutually exclusive, unless expressly specified otherwise.

The terms "a", "an" and "the" mean "one or more", unless expressly specified otherwise.

A description of an embodiment with several components in communication with each other does not imply that all such components are required. On the contrary a variety of optional components are described to illustrate the wide variety of possible embodiments of the invention.

When a single device or article is described herein, it will be readily apparent that more than one device/article (whether or not they cooperate) may be used in place of a single device/article. Similarly, where more than one device or article is described herein (whether or not they cooperate), it will be readily apparent that a single device/article may be used in place of the more than one device or article or a different number of devices/articles may be used instead of the shown number of devices of programs. The functionality and/or the features of a device may be alternatively embodied by one or more other devices which are not explicitly described as having such functionality/features. Thus, other embodiments of the invention need not include the device itself.

The illustrated operations of **Figure 7** show certain events occurring in a certain order. In alternative embodiments, certain operations may be performed in a different order, modified, or removed. Moreover, steps may be added to the above described logic and still conform to the described embodiments. Further, operations described herein may occur sequentially or certain operations may be processed in parallel. Yet further, operations may be performed by a single processing unit or by distributed processing units.

Finally, the language used in the specification has been principally selected for readability and instructional purposes, and it may not have been selected to delineate or circumscribe the inventive subject matter. It is therefore intended that the scope of the invention be limited not by this detailed description, but rather by any claims that issue on an application based here on. Accordingly, the disclosure of the embodiments of the invention is intended to be illustrative, but not limiting, of the scope of the invention, which is set forth in the following claims.

While various aspects and embodiments have been disclosed herein, other aspects and embodiments will be apparent to those skilled in the art. The various aspects and embodiments disclosed herein are for purposes of illustration and are not intended to be limiting, with the true scope being indicated by the following claims.

**Referral numerals:**

| Reference Number | Description |
|---|---|
| 100 | Exemplary Environment |
| 101 | Estimation Unit |
| 102 | Battery |
| 103 | Electric Vehicle |
| 104 | Communication Network |
| 105 | Processor |
| 106 | I/O interface |
| 107 | Memory |
| 108 | Modules |
| 109 | Data |
| 201 | SOH Reception Module |
| 202 | Voltage Profile Prediction Module |
| 203 | Dynamic Capacity Estimation Module |
| 204 | Longevity Index Determination Module |
| 205 | Breakdown Index Prediction Module |
| 206 | Other Modules |
| 207 | SOH Data |
| 208 | Geo-location Data |
| 209 | Usage Data |
| 210 | Voltage Profile Data |
| 211 | Dynamic Capacity Data |
| 212 | Longevity Index Data |
| 213 | Breakdown Index Data |
| 214 | Load Profile Data |
| 215 | Energy Information Data |
| 216 | Other Data |
| 301 | Voltage Window Determination Unit |
| 302 | Resistance Behaviour Determination Unit |
| 303 | OCV Window Estimation Unit |
| 304 | First OCV Profile Estimation Unit |
| 305 | Ideal Voltage Profile Prediction Unit |
| 306 | Ideal Voltage Profile Prediction Unit for Smoother Usage |
| 307 | Ideal Voltage Profile Prediction Unit for Aggressive Usage |
| 308 | Energy Estimation Unit for Future Journey Information |
| 309 | SOC Estimation Unit of Battery |
| 310 | SOC Profile Estimation Unit |
| 311 | Second OCV Profile Estiniation Unit |

(continued)

| Reference Number | Description |
|---|---|
| 312 | Real-Time Voltage Profile Prediction Unit |
| 313 | Database |
| 314 | Plot For Resistance Behaviour of Battery |
| 315 | Plot For Voltage Window of Battery |
| 316 | Plot For OCV Window |
| 317 | Plot For First OCV Profile |
| 318 | Plot For Ideal Voltage Profile |
| 401 | Battery Pack Model |
| 402 | Ideal Voltage Profile Prediction Unit |
| 403 | Real-Time Voltage Profile Prediction Unit |
| 404 | Dynamic Capacity Estimation Unit |
| 406 | Plot for Dynamic Capacity |
| 407 | Dynamic Capacity for Ideal Condition |
| 408 | Dynamic Capacity for Current usage |
| 501 | Weibull Parameters Provide Unit |
| 502 | Plot for Longevity Index |
| 503 | Longevity For Ideal Condition |
| 504 | Longevity For Current Usage |
| 505 | Longevity For Smoother Usage |
| 506 | Longevity For Aggressive Usage |
| 601 | Plot for Breakdown Index |
| 602 | Breakdown For Aggressive Usage |
| 603 | Breakdown For Current Usage |
| 604 | Breakdown For Smoother Usage |
| 800 | Computer System |
| 801 | I/O Interface |
| 802 | Processor |
| 803 | Network Interface |
| 804 | Storage Interface |
| 805 | Memory |
| 806 | User Interface |
| 807 | Operating System |
| 808 | Web Browser |
| 809 | Input Devices |
| 810 | Output Devices |
| 811 | Communication Network |

**Claims**

1. A method for estimating one or more dynamic capacities of a battery (102) for an electric vehicle (103), for one or more usages of the electric vehicle (103), comprising:

   receiving, by an estimation unit (101), state of health data of the battery (102) of the electric vehicle (103), wherein the state of health data comprises capacity state of health (SOHQ) and resistance state of health (SOHR) of the battery (102);

   predicting, by the estimation unit (101), ideal voltage profiles and a real-time voltage profile of the battery (102), wherein

   the ideal voltage profiles are predicted for each of the one or more usages of the electric vehicle (103), based on the capacity state of health (SOHQ), the resistance state of health (SOHR), and one or more load profiles of the battery (102), wherein

   the real-time voltage profile is predicted based on the capacity state of health (SOHQ), the resistance state of health (SOHR), geo-location data (208) of the electric vehicle (103), and one or more load profiles of the battery (102); and

   estimating, by the estimation unit (101), the one or more dynamic capacities of the battery (102) for the one or more usages, based on the ideal voltage profiles and the real-time voltage profile, wherein

   the one or more usages of the electric vehicle (103) include current usage of the electric vehicle (103), smoother usage of the electric vehicle (103) and aggressive usage of the electric vehicle (103), wherein

   the one or more dynamic capacities correspond to a capacity of the battery (102) which is extractable from the battery (102) for use or running of the electric vehicle (103),

   wherein

   each of the ideal voltage profiles indicates voltages determined for corresponding usage from the one or more usages of the electric vehicle (103), wherein

   predicting the ideal voltage profiles comprises:

      determining a voltage window of the battery (102) for each of the one or more usages of the electric vehicle (103), from a measured load profile of the one or more load profiles, the measured load profile indicating values of current measured for a present route and velocity of the electric vehicle (103);

      determining resistance behavior of the battery (102) by comparing SOC and the resistance state of health (SOHR);

      estimating first Open Circuit Voltage (OCV) profiles of the battery (102) based on OCV windows estimated from the determined voltage window based on the resistance behavior, for each of the one or more usage profiles;

      estimating full OCV profiles of the battery (102) based on an offset method, wherein the offset method indicates an average difference between the full OCV profiles and the estimated first OCV profiles; and

      predicting the ideal voltage profiles for each of the one or more usage profiles, based on the full OCV profiles, the resistance behavior, and a predefined discharge rate of the battery (102), and wherein

      the real-time voltage profile indicates voltage determined for the current usage of the electric vehicle (103), wherein

      predicting the real-time voltage profile comprises:

         determining an SOC profile of the battery (102) for future journey information;

         estimating a second OCV profile of the battery (102), based on the determined SOC profile and predicted load profile of the one or more load profiles for the future journey information of the electric vehicle (103) and a start SOC of the battery (102), wherein

         the predicted load profile indicates values of current estimated for geo-location data (208), a future journey route and velocity of the electric vehicle (103); and

         predicting the real-time voltage profile, based on the second OCV profile, resistance behavior of the battery (102), and a predefined discharge rate of the battery (102).

2. The method as claimed in claim 1 further comprises:
   determining, by the estimation unit (101), longevity index of the battery (102) for the one or more usages, based on the estimated one or more dynamic capacities.

3. The method as claimed in claim 1 further comprises:

predicting, by the estimation unit (101), breakdown index of the battery (102) for the one or more usages, based on the estimated one or more dynamic capacities and energy information, wherein the energy information indicates energy and rate of the energy required from the battery (102) with respect to future journey information of the electric vehicle (103).

4. The method as claimed in claim 1, wherein

the state of health data is based on battery pack model (401) related to the battery, wherein
the battery pack model (401) is periodically updated using real-time battery data comprising current data, voltage data, temperature data and State Of Charge (SOC) data related to the battery (102).

5. The method as claimed in claim 1, wherein
estimating the one or more dynamic capacities for the one or more usages, further comprises:

comparing ideal voltage profiles and real-time voltage profile, to obtain value of voltage of the battery (102), wherein the voltage drops to reach a predefined lower limit of the voltage, wherein
the predefined lower limit indicates when Battery Management System (BMS) stops discharge of the battery (102);
identifying total capacity discharged by the battery (102) based on the value of voltage of the battery (102); and
comparing the total capacity for corresponding usage from the one or more usages with capacity state of health of the battery (102), to estimate the one or more dynamic capacities for the one or more usages.

6. An estimation unit (101) for estimating one or more dynamic capacities of a battery (102) for an electric vehicle (103), for one or more usages of the electric vehicle (103), said estimation unit (101) comprises:

a processor (105); and
a memory (107) communicatively coupled to the processor (105), wherein the memory (107) stores processor-executable instructions, which, on execution, cause the processor (105) to:

receive state of health data of the battery (102) of the electric vehicle (103), wherein
the state of health data comprises capacity state of health (SOHQ) and resistance state of health (SOHR) of the battery (102);
predict ideal voltage profiles and a real-time voltage profile of the battery (102), wherein
the ideal voltage profiles are predicted for each of the one or more usages of the electric vehicle (103), based on the capacity state of health (SOHQ), the resistance state of health (SOHR), and one or more load profiles of the battery (102), wherein
the real-time voltage profile is predicted based on the capacity state of health (SOHQ), the resistance state of health (SOHR), geo-location data (208) of the electric vehicle (103), and one or more load profiles of the battery (102); and
estimate the one or more dynamic capacities of the battery (102) for the one or more usages, based on the ideal voltage profiles and the real-time voltage profile, wherein
the one or more usages of the electric vehicle (103) include current usage of the electric vehicle (103), smoother usage of the electric vehicle (103) and aggressive usage of the electric vehicle (103), wherein the one or more dynamic capacities correspond to a capacity of the battery (102) which is extractable from the battery (102) for use or running of the electric vehicle (103), wherein
each of the ideal voltage profiles indicates voltages determined for corresponding usage from the one or more usages of the electric vehicle (103), wherein the processor (105) is configured to predict the ideal voltage profiles by:

determining a voltage window of the battery (102) for each of the one or more usages of the electric vehicle (103), from a measured load profile of the one or more load profiles, the measured load profile indicating values of current measured for present route and velocity of the electric vehicle (103);
determining resistance behavior of the battery (102) by comparing SOC and the resistance state of health (SOHR);
estimating first Open Circuit Voltage (OCV) profiles of the battery (102) based on OCV windows estimated from the determined voltage window based on the resistance behavior, for each of the one or more usage profiles;

estimating full OCV profiles of the battery (102) based on an offset method, wherein
the offset method indicates an average difference between the full OCV profiles and the estimated first OCV profile; and
predicting the ideal voltage profiles for each of the one or more usage profiles, based on the full OCV profiles, the resistance behavior and a predefined discharge rate of the battery (102), and wherein the real-time voltage profile indicates voltage determined for the current usage of the electric vehicle (103), wherein the processor (105) is configured to predict the real-time voltage profile by:

determining an SOC profile of the battery (102) for future journey information;
estimating a second OCV profile of the battery (102), based on the determined SOC profile and predicted load profile of the one or more load profiles for the future journey information of the electric vehicle (103) and a start SOC of the battery (102), wherein
the predicted load profile indicates values of current estimated for geo-location data (208), a future journey route and velocity of the electric vehicle (103); and
predicting the real-time voltage profile, based on the second OCV profile, resistance behavior of the battery (102), and a predefined discharge rate of the battery (102).

7. The estimation unit (101) as claimed in claim 6 further comprises the processor (105) to:
determine longevity index of the battery (102) for the one or more usages, based on the estimated one or more dynamic capacities.

8. The estimation unit (101) as claimed in claim 6 further comprises the processor (105) to:

predict breakdown index of the battery (102) for the one or more usages, based on the estimated one or more dynamic capacities and energy information, wherein
the energy information indicates energy and rate of the energy required from the battery (102) with respect to future journey information of the electric vehicle (103).

9. The estimation unit (101) as claimed in claim 6, wherein

the state of health data is based on battery pack model (401) related to the battery (102), wherein
the battery pack model (401) is periodically updated using real-time battery data comprising current data, voltage data, temperature data and State Of Charge (SOC) data related to the battery (102).

10. The estimation unit (101) as claimed in claim 6, wherein
the processor (105) is configured to estimate the one or more dynamic capacities for the one or more usages by:

comparing ideal voltage profiles and real-time voltage profile, to obtain value of voltage of the battery (102), wherein the voltage, drops to reach a predefined lower limit of the voltage, wherein
the predefined lower limit indicates when Battery Management System (BMS) stops discharge of the battery (102);
identifying total capacity discharged by the battery (102) based on the value of voltage of the battery (102); and
comparing the total capacity for corresponding usage from the one or more usages with capacity state of health of the battery (102), to estimate the one or more dynamic capacities for the one or more usages.

**Patentansprüche**

1. Verfahren zum Schätzen einer oder mehrerer dynamischer Kapazitäten einer Batterie (102) für ein Elektrofahrzeug (103) für eine oder mehrere Nutzungen des Elektrofahrzeugs (103), umfassend:

Empfangen von Gesundheitszustandsdaten der Batterie (102) des Elektrofahrzeugs (103) durch eine Schätzeinheit (101), wobei
die Gesundheitszustandsdaten einen Kapazitätsgesundheitszustand (SOHQ) und einen Widerstandsgesundheitszustand (SOHR) der Batterie (102) umfassen;
Vorhersagen von idealen Spannungsprofilen und eines Echtzeit-Spannungsprofils der Batterie (102) durch die Schätzeinheit (101), wobei
die idealen Spannungsprofile für jede der einen oder mehreren Nutzungen des Elektrofahrzeugs (103) basierend auf dem Kapazitätsgesundheitszustand (SOHQ), dem Widerstandsgesundheitszustand (SOHR) und einem oder mehreren Lastprofilen der Batterie (102) vorhergesagt werden, wobei

das Echtzeit-Spannungsprofil basierend auf dem Kapazitätsgesundheitszustand (SOHQ), dem Widerstandsgesundheitszustand (SOHR), Geolokalisierungsdaten (208) des Elektrofahrzeugs (103) und einem oder mehreren Lastprofilen der Batterie (102) vorhergesagt wird; und

Schätzen der einen oder mehreren dynamischen Kapazitäten der Batterie (102) für die eine oder mehreren Nutzungen durch die Schätzeinheit (101) basierend auf den idealen Spannungsprofilen und dem Echtzeit-Spannungsprofil, wobei

die eine oder mehreren Nutzungen des Elektrofahrzeugs (103) eine aktuelle Nutzung des Elektrofahrzeugs (103), eine gleichmäßigere Nutzung des Elektrofahrzeugs (103) und eine aggressive Nutzung des Elektrofahrzeugs (103) beinhalten, wobei die eine oder mehreren dynamischen Kapazitäten einer Kapazität der Batterie (102) entsprechen, die aus der Batterie (102) zur Nutzung oder zum Betrieb des Elektrofahrzeugs (103) extrahierbar ist, wobei

jedes der idealen Spannungsprofile Spannungen angibt, die für eine entsprechende Nutzung aus der einen oder den mehreren Nutzungen des Elektrofahrzeugs (103) bestimmt werden, wobei

das Vorhersagen der idealen Spannungsprofile Folgendes umfasst:

Bestimmen eines Spannungsfensters der Batterie (102) für jede der einen oder mehreren Nutzungen des Elektrofahrzeugs (103) aus einem gemessenen Lastprofil des einen oder der mehreren Lastprofile, wobei das gemessene Lastprofil Werte des Stroms angibt, die für eine aktuelle Strecke und Geschwindigkeit des Elektrofahrzeugs (103) gemessen werden;

Bestimmen eines Widerstandsverhaltens der Batterie (102) durch Vergleichen des SOC und des Widerstandsgesundheitszustands (SOHR);

Schätzen erster Leerlaufspannungsprofile (OCV-Profile) der Batterie (102) basierend auf OCV-Fenstern, die aus dem bestimmten Spannungsfenster basierend auf dem Widerstandsverhalten geschätzt werden, für jedes des einen oder der mehreren Nutzungsprofile;

Schätzen vollständiger OCV-Profile der Batterie (102) basierend auf einem Versatzverfahren, wobei das Versatzverfahren eine durchschnittliche Differenz zwischen den vollständigen OCV-Profilen und den geschätzten ersten OCV-Profilen angibt; und

Vorhersagen der idealen Spannungsprofile für jedes des einen oder der mehreren Nutzungsprofile basierend auf den vollständigen OCV-Profilen, dem Widerstandsverhalten und einer vordefinierten Entladungsrate der Batterie (102), und wobei

das Echtzeit-Spannungsprofil Spannung angibt, die für die aktuelle Nutzung des Elektrofahrzeugs (103) bestimmt wird, wobei

das Vorhersagen des Echtzeit-Spannungsprofils Folgendes umfasst:

Bestimmen eines SOC-Profils der Batterie (102) für zukünftige Fahrtinformationen;

Schätzen eines zweiten OCV-Profils der Batterie (102) basierend auf dem bestimmten SOC-Profil und dem vorhergesagten Lastprofil des einen oder der mehreren Lastprofile für die zukünftigen Fahrtinformationen des Elektrofahrzeugs (103) und einem Start-SOC der Batterie (102), wobei das vorhergesagte Lastprofil Werte des Stroms angibt, die für Geolokalisierungsdaten (208), eine zukünftige Fahrtstrecke und Geschwindigkeit des Elektrofahrzeugs (103) geschätzt werden; und

Vorhersagen des Echtzeit-Spannungsprofils basierend auf dem zweiten OCV-Profil, dem Widerstandsverhalten der Batterie (102) und einer vordefinierten Entladungsrate der Batterie (102).

2. Verfahren nach Anspruch 1, ferner umfassend:
Bestimmen eines Langlebigkeitsindex der Batterie (102) für die eine oder mehreren Nutzungen durch die Schätzeinheit (101) basierend auf der geschätzten einen oder den geschätzten mehreren dynamischen Kapazitäten.

3. Verfahren nach Anspruch 1, ferner umfassend:
Vorhersagen eines Ausfallindex der Batterie (102) für die eine oder mehreren Nutzungen durch die Schätzeinheit (101) basierend auf der geschätzten einen oder den geschätzten mehreren dynamischen Kapazitäten und Energieinformationen, wobei die Energieinformationen Energie und Rate der Energie angeben, die von der Batterie (102) in Bezug auf zukünftige Fahrtinformationen des Elektrofahrzeugs (103) benötigt wird.

4. Verfahren nach Anspruch 1, wobei

die Gesundheitszustandsdaten auf einem Batteriepackmodell (401) basieren, das sich auf die Batterie bezieht, wobei

das Batteriepackmodell (401) unter Verwendung von Echtzeit-Batteriedaten, die Stromdaten, Spannungsdaten, Temperaturdaten und Ladezustandsdaten (SOC-Daten) umfassen, die sich auf die Batterie (102) beziehen, periodisch aktualisiert wird.

**5.** Verfahren nach Anspruch 1, wobei
das Schätzen der einen oder der mehreren dynamischen Kapazitäten für die eine oder die mehreren Nutzungen ferner Folgendes umfasst:

Vergleichen von idealen Spannungsprofilen und einem Echtzeit-Spannungsprofil, um einen Spannungswert der Batterie (102) zu erhalten, wobei die Spannung fällt, um eine vordefinierte Untergrenze der Spannung zu erreichen, wobei
die vordefinierte Untergrenze angibt, wann das Batteriemanagementsystem (BMS) die Entladung der Batterie (102) stoppt;
Identifizieren der von der Batterie (102) entladenen Gesamtkapazität basierend auf dem Spannungswert der Batterie (102); und
Vergleichen der Gesamtkapazität für die entsprechende Nutzung aus der einen oder den mehreren Nutzungen mit dem Kapazitätsgesundheitszustand der Batterie (102), um die eine oder die mehreren dynamischen Kapazitäten für die eine oder die mehreren Nutzungen zu schätzen.

**6.** Schätzeinheit (101) zum Schätzen einer oder mehrerer dynamischer Kapazitäten einer Batterie (102) für ein Elektrofahrzeug (103) für eine oder mehrere Nutzungen des Elektrofahrzeugs (103), wobei die Schätzeinheit (101) umfasst:

einen Prozessor (105); und
einen Speicher (107), der kommunikativ mit dem Prozessor (105) gekoppelt ist, wobei der Speicher (107) prozessorausführbare Anweisungen speichert, die bei Ausführung den Prozessor (105) veranlassen zum:

Empfangen von Gesundheitszustandsdaten der Batterie (102) des Elektrofahrzeugs (103), wobei die Gesundheitszustandsdaten einen Kapazitätsgesundheitszustand (SOHQ) und einen Widerstandsgesundheitszustand (SOHR) der Batterie (102) umfassen;
Vorhersagen von idealen Spannungsprofilen und eines Echtzeit-Spannungsprofils der Batterie (102), wobei die idealen Spannungsprofile für jede der einen oder mehreren Nutzungen des Elektrofahrzeugs (103) basierend auf dem Kapazitätsgesundheitszustand (SOHQ), dem Widerstandsgesundheitszustand (SOHR) und einem oder mehreren Lastprofilen der Batterie (102) vorhergesagt werden, wobei
das Echtzeit-Spannungsprofil basierend auf dem Kapazitätsgesundheitszustand (SOHQ), dem Widerstandsgesundheitszustand (SOHR), Geolokalisierungsdaten (208) des Elektrofahrzeugs (103) und einem oder mehreren Lastprofilen der Batterie (102) vorhergesagt wird; und
Schätzen der einen oder mehreren dynamischen Kapazitäten der Batterie (102) für die eine oder mehreren Nutzungen basierend auf den idealen Spannungsprofilen und dem Echtzeit-Spannungsprofil, wobei
die eine oder mehreren Nutzungen des Elektrofahrzeugs (103) eine aktuelle Nutzung des Elektrofahrzeugs (103), eine gleichmäßigere Nutzung des Elektrofahrzeugs (103) und eine aggressive Nutzung des Elektrofahrzeugs (103) beinhalten, wobei die eine oder mehreren dynamischen Kapazitäten einer Kapazität der Batterie (102) entsprechen, die aus der Batterie (102) zur Nutzung oder zum Betrieb des Elektrofahrzeugs (103) extrahierbar ist, wobei
jedes der idealen Spannungsprofile Spannungen angibt, die für eine entsprechende Nutzung aus der einen oder den mehreren Nutzungen des Elektrofahrzeugs (103) bestimmt werden, wobei der Prozessor (105) konfiguriert ist, um die idealen Spannungsprofile durch Folgendes vorherzusagen:

Bestimmen eines Spannungsfensters der Batterie (102) für jede der einen oder mehreren Nutzungen des Elektrofahrzeugs (103) aus einem gemessenen Lastprofil des einen oder der mehreren Lastprofile, wobei das gemessene Lastprofil Werte des Stroms angibt, die für eine aktuelle Strecke und Geschwindigkeit des Elektrofahrzeugs (103) gemessen werden;
Bestimmen eines Widerstandsverhaltens der Batterie (102) durch Vergleichen des SOC und des Widerstandsgesundheitszustands (SOHR);
Schätzen erster Leerlaufspannungsprofile (OCV-Profile) der Batterie (102) basierend auf OCV-Fenstern, die aus dem bestimmten Spannungsfenster basierend auf dem Widerstandsverhalten geschätzt werden, für jedes des einen oder der mehreren Nutzungsprofile;

Schätzen vollständiger OCV-Profile der Batterie (102) basierend auf einem Versatzverfahren, wobei das Versatzverfahren eine durchschnittliche Differenz zwischen den vollständigen OCV-Profilen und dem geschätzten ersten OCV-Profil angibt; und

Vorhersagen der idealen Spannungsprofile für jedes des einen oder der mehreren Nutzungsprofile basierend auf den vollständigen OCV-Profilen, dem Widerstandsverhalten und einer vordefinierten Entladungsrate der Batterie (102), und wobei

das Echtzeit-Spannungsprofil Spannung angibt, die für die aktuelle Nutzung des Elektrofahrzeugs (103) bestimmt wird, wobei der Prozessor (105) konfiguriert ist, um das Echtzeit-Spannungsprofil durch Folgendes vorherzusagen:

Bestimmen eines SOC-Profils der Batterie (102) für zukünftige Fahrtinformationen;
Schätzen eines zweiten OCV-Profils der Batterie (102) basierend auf dem bestimmten SOC-Profil und dem vorhergesagten Lastprofil des einen oder der mehreren Lastprofile für die zukünftigen Fahrtinformationen des Elektrofahrzeugs (103) und einem Start-SOC der Batterie (102), wobei das vorhergesagte Lastprofil Werte des Stroms angibt, die für Geolokalisierungsdaten (208), eine zukünftige Fahrtstrecke und Geschwindigkeit des Elektrofahrzeugs (103) geschätzt werden; und
Vorhersagen des Echtzeit-Spannungsprofils basierend auf dem zweiten OCV-Profil, dem Widerstandsverhalten der Batterie (102) und einer vordefinierten Entladungsrate der Batterie (102).

7.  Schätzeinheit (101) nach Anspruch 6, ferner umfassend den Prozessor (105) zum:
Bestimmen eines Langlebigkeitsindex der Batterie (102) für die eine oder mehreren Nutzungen basierend auf der geschätzten einen oder den geschätzten mehreren dynamischen Kapazitäten.

8.  Schätzeinheit (101) nach Anspruch 6, ferner umfassend den Prozessor (105) zum:

Vorhersagen eines Ausfallindex der Batterie (102) für die eine oder mehreren Nutzungen basierend auf der geschätzten einen oder den geschätzten mehreren dynamischen Kapazitäten und Energieinformationen, wobei die Energieinformationen Energie und Rate der Energie angeben, die von der Batterie (102) in Bezug auf zukünftige Fahrtinformationen des Elektrofahrzeugs (103) benötigt wird.

9.  Schätzeinheit (101) nach Anspruch 6, wobei

die Gesundheitszustandsdaten auf einem Batteriepackmodell (401) basieren, das sich auf die Batterie (102) bezieht, wobei
das Batteriepackmodell (401) unter Verwendung von Echtzeit-Batteriedaten, die Stromdaten, Spannungsdaten, Temperaturdaten und Ladezustandsdaten (SOC-Daten) umfassen, die sich auf die Batterie (102) beziehen, periodisch aktualisiert wird.

10. Schätzeinheit (101) nach Anspruch 6, wobei
der Prozessor (105) konfiguriert ist, um die eine oder die mehreren dynamischen Kapazitäten für die eine oder die mehreren Nutzungen durch Folgendes zu schätzen:

Vergleichen von idealen Spannungsprofilen und einem Echtzeit-Spannungsprofil, um einen Spannungswert der Batterie (102) zu erhalten, wobei die Spannung fällt, um eine vordefinierte Untergrenze der Spannung zu erreichen, wobei
die vordefinierte Untergrenze angibt, wann das Batteriemanagementsystem (BMS) die Entladung der Batterie (102) stoppt;
Identifizieren der von der Batterie (102) entladenen Gesamtkapazität basierend auf dem Spannungswert der Batterie (102); und
Vergleichen der Gesamtkapazität für die entsprechende Nutzung aus der einen oder den mehreren Nutzungen mit dem Kapazitätsgesundheitszustand der Batterie (102), um die eine oder die mehreren dynamischen Kapazitäten für die eine oder die mehreren Nutzungen zu schätzen.

## Revendications

1.  Procédé d'estimation d'une ou plusieurs capacités dynamiques d'une batterie (102) pour un véhicule électrique (103), pour une ou plusieurs utilisations du véhicule électrique (103), comprenant :

la réception, par une unité d'estimation (101), de données d'état de santé de la batterie (102) du véhicule électrique (103), dans lequel

les données d'état de santé comprennent un état de santé de capacité (SOHQ) et un état de santé de résistance (SOHR) de la batterie (102) ;

la prédiction, par l'unité d'estimation (101), de profils de tension idéaux et d'un profil de tension en temps réel de la batterie (102), dans lequel

les profils de tension idéaux sont prédits pour chacune des une ou plusieurs utilisations du véhicule électrique (103), sur la base de l'état de santé de capacité (SOHQ), de l'état de santé de résistance (SOHR), et d'un ou plusieurs profils de charge de la batterie (102), dans lequel

le profil de tension en temps réel est prédit sur la base de l'état de santé de capacité (SOHQ), de l'état de santé de résistance (SOHR), de données de géolocalisation (208) du véhicule électrique (103), et d'un ou plusieurs profils de charge de la batterie (102) ; et

l'estimation, par l'unité d'estimation (101), des une ou plusieurs capacités dynamiques de la batterie (102) pour les une ou plusieurs utilisations, sur la base des profils de tension idéaux et du profil de tension en temps réel, dans lequel

les une ou plusieurs utilisations du véhicule électrique (103) comprennent une utilisation actuelle du véhicule électrique (103), une utilisation plus douce du véhicule électrique (103) et une utilisation agressive du véhicule électrique (103), dans lequel

les une ou plusieurs capacités dynamiques correspondent à une capacité de la batterie (102) qui peut être extraite de la batterie (102) pour une utilisation ou un fonctionnement du véhicule électrique (103), dans lequel

chacun des profils de tension idéaux indique des tensions déterminées pour une utilisation correspondante parmi les une ou plusieurs utilisations du véhicule électrique (103), dans lequel

la prédiction des profils de tension idéaux comprend :

la détermination d'une fenêtre de tension de la batterie (102) pour chacune des une ou plusieurs utilisations du véhicule électrique (103), à partir d'un profil de charge mesuré des un ou plusieurs profils de charge, le profil de charge mesuré indiquant des valeurs de courant mesurées pour un itinéraire et une vitesse actuels du véhicule électrique (103) ;

la détermination d'un comportement de résistance de la batterie (102) en comparant un SOC et l'état de santé de résistance (SOHR) ;

l'estimation de premiers profils de tension en circuit ouvert (OCV) de la batterie (102) sur la base de fenêtres OCV estimées à partir de la fenêtre de tension déterminée sur la base du comportement de résistance, pour chacun des un ou plusieurs profils d'utilisation ;

l'estimation de profils OCV complets de la batterie (102) sur la base d'un procédé de décalage, dans lequel le procédé de décalage indique une différence moyenne entre les profils OCV complets et les premiers profils OCV estimés ; et

la prédiction des profils de tension idéaux pour chacun des un ou plusieurs profils d'utilisation, sur la base des profils OCV complets, du comportement de résistance, et d'un taux de décharge prédéfini de la batterie (102), et dans lequel

le profil de tension en temps réel indique une tension déterminée pour l'utilisation actuelle du véhicule électrique (103), dans lequel

la prédiction du profil de tension en temps réel comprend :

la détermination d'un profil SOC de la batterie (102) pour des informations de voyage futur ;

l'estimation d'un second profil OCV de la batterie (102), sur la base du profil SOC déterminé et d'un profil de charge prédit des un ou plusieurs profils de charge pour les informations de voyage futur du véhicule électrique (103) et d'un SOC de démarrage de la batterie (102), dans lequel

le profil de charge prédit indique des valeurs de courant estimées pour des données de géolocalisation (208), un itinéraire et une vitesse de voyage futur du véhicule électrique (103) ; et

la prédiction du profil de tension en temps réel, sur la base du second profil OCV, d'un comportement de résistance de la batterie (102), et d'un taux de décharge prédéfini de la batterie (102).

2. Procédé selon la revendication 1, comprenant en outre :
la détermination, par l'unité d'estimation (101), d'un indice de longévité de la batterie (102) pour les une ou plusieurs utilisations, sur la base des une ou plusieurs capacités dynamiques estimées.

3. Procédé selon la revendication 1, comprenant en outre :
la prédiction, par l'unité d'estimation (101), d'un indice de panne de la batterie (102) pour les une ou plusieurs utilisations, sur la base des une ou plusieurs capacités dynamiques estimées et d'informations d'énergie, dans lequel les informations d'énergie indiquent l'énergie et le taux de l'énergie requise par la batterie (102) par rapport à des informations de voyage futur du véhicule électrique (103).

4. Procédé selon la revendication 1, dans lequel

les données d'état de santé sont basées sur un modèle de bloc-batterie (401) associé à la batterie, dans lequel le modèle de bloc-batterie (401) est périodiquement mis à jour en utilisant des données de batterie en temps réel comprenant des données de courant, des données de tension, des données de température et des données d'état de charge (SOC) associées à la batterie (102).

5. Procédé selon la revendication 1, dans lequel
l'estimation des une ou plusieurs capacités dynamiques pour les une ou plusieurs utilisations, comprend en outre :

la comparaison de profils de tension idéaux et d'un profil de tension en temps réel, pour obtenir une valeur de tension de la batterie (102), dans lequel la tension chute pour atteindre une limite inférieure prédéfinie de la tension, dans lequel
la limite inférieure prédéfinie indique quand un système de gestion de batterie (BMS) arrête la décharge de la batterie (102) ;
l'identification d'une capacité totale déchargée par la batterie (102) sur la base de la valeur de tension de la batterie (102) ; et
la comparaison de la capacité totale pour une utilisation correspondante parmi les une ou plusieurs utilisations avec un état de santé de capacité de la batterie (102), pour estimer les une ou plusieurs capacités dynamiques pour les une ou plusieurs utilisations.

6. Unité d'estimation (101) pour estimer une ou plusieurs capacités dynamiques d'une batterie (102) pour un véhicule électrique (103), pour une ou plusieurs utilisations du véhicule électrique (103), ladite unité d'estimation (101) comprenant :

un processeur (105) ; et
une mémoire (107) couplée en communication au processeur (105), dans laquelle la mémoire (107) stocke des instructions exécutables par processeur qui, lors de l'exécution, amènent le processeur (105) à :

recevoir des données d'état de santé de la batterie (102) du véhicule électrique (103), dans laquelle les données d'état de santé comprennent un état de santé de capacité (SOHQ) et un état de santé de résistance (SOHR) de la batterie (102) ;
prédire des profils de tension idéaux et un profil de tension en temps réel de la batterie (102), dans laquelle les profils de tension idéaux sont prédits pour chacune des une ou plusieurs utilisations du véhicule électrique (103), sur la base de l'état de santé de capacité (SOHQ), de l'état de santé de résistance (SOHR), et d'un ou plusieurs profils de charge de la batterie (102), dans laquelle le profil de tension en temps réel est prédit sur la base de l'état de santé de capacité (SOHQ), de l'état de santé de résistance (SOHR), de données de géolocalisation (208) du véhicule électrique (103), et d'un ou plusieurs profils de charge de la batterie (102) ; et
estimer les une ou plusieurs capacités dynamiques de la batterie (102) pour les une ou plusieurs utilisations, sur la base des profils de tension idéaux et du profil de tension en temps réel, dans laquelle les une ou plusieurs utilisations du véhicule électrique (103) comprennent une utilisation actuelle du véhicule électrique (103), une utilisation plus douce du véhicule électrique (103) et une utilisation agressive du véhicule électrique (103), dans laquelle
les une ou plusieurs capacités dynamiques correspondent à une capacité de la batterie (102) qui peut être extraite de la batterie (102) pour une utilisation ou un fonctionnement du véhicule électrique (103), dans laquelle
chacun des profils de tension idéaux indique des tensions déterminées pour une utilisation correspondante parmi les une ou plusieurs utilisations du véhicule électrique (103), dans laquelle le processeur (105) est configuré pour prédire les profils de tension idéaux en :

déterminant une fenêtre de tension de la batterie (102) pour chacune des une ou plusieurs utilisations du véhicule électrique (103), à partir d'un profil de charge mesuré des un ou plusieurs profils de charge, le profil de charge mesuré indiquant des valeurs de courant mesurées pour un itinéraire et une vitesse actuels du véhicule électrique (103) ;

déterminant un comportement de résistance de la batterie (102) en comparant un SOC et l'état de santé de résistance (SOHR) ;

estimant des premiers profils de tension en circuit ouvert (OCV) de la batterie (102) sur la base de fenêtres OCV estimées à partir de la fenêtre de tension déterminée sur la base du comportement de résistance, pour chacun des un ou plusieurs profils d'utilisation ;

estimant des profils OCV complets de la batterie (102) sur la base d'un procédé de décalage, dans laquelle

le procédé de décalage indique une différence moyenne entre les profils OCV complets et le premier profil OCV estimé ; et

prédire les profils de tension idéaux pour chacun des un ou plusieurs profils d'utilisation, sur la base des profils OCV complets, du comportement de résistance et d'un taux de décharge prédéfini de la batterie (102), et dans laquelle

le profil de tension en temps réel indique une tension déterminée pour l'utilisation actuelle du véhicule électrique (103), dans laquelle le processeur (105) est configuré pour prédire le profil de tension en temps réel en :

déterminant un profil SOC de la batterie (102) pour des informations de voyage futur ;

estimant un second profil OCV de la batterie (102), sur la base du profil SOC déterminé et d'un profil de charge prédit des un ou plusieurs profils de charge pour les informations de voyage futur du véhicule électrique (103) et d'un SOC de démarrage de la batterie (102), dans laquelle

le profil de charge prédit indique des valeurs de courant estimées pour des données de géolocalisation (208), un itinéraire et une vitesse de voyage futur du véhicule électrique (103) ; et

prédire le profil de tension en temps réel, sur la base du second profil OCV, d'un comportement de résistance de la batterie (102), et d'un taux de décharge prédéfini de la batterie (102).

7. Unité d'estimation (101) selon la revendication 6, comprenant en outre le processeur (105) pour :
déterminer un indice de longévité de la batterie (102) pour les une ou plusieurs utilisations, sur la base des une ou plusieurs capacités dynamiques estimées.

8. Unité d'estimation (101) selon la revendication 6, comprenant en outre le processeur (105) pour :

prédire un indice de panne de la batterie (102) pour les une ou plusieurs utilisations, sur la base des une ou plusieurs capacités dynamiques estimées et d'informations d'énergie, dans laquelle

les informations d'énergie indiquent l'énergie et le taux de l'énergie requise par la batterie (102) par rapport à des informations de voyage futur du véhicule électrique (103).

9. Unité d'estimation (101) selon la revendication 6, dans laquelle

les données d'état de santé sont basées sur un modèle de bloc-batterie (401) associé à la batterie (102), dans laquelle

le modèle de bloc-batterie (401) est périodiquement mis à jour en utilisant des données de batterie en temps réel comprenant des données de courant, des données de tension, des données de température et des données d'état de charge (SOC) associées à la batterie (102).

10. Unité d'estimation (101) selon la revendication 6, dans laquelle
le processeur (105) est configuré pour estimer les une ou plusieurs capacités dynamiques pour les une ou plusieurs utilisations en :

comparant des profils de tension idéaux et un profil de tension en temps réel, pour obtenir une valeur de tension de la batterie (102), dans laquelle la tension chute pour atteindre une limite inférieure prédéfinie de la tension, dans laquelle

la limite inférieure prédéfinie indique quand un système de gestion de batterie (BMS) arrête la décharge de la batterie (102) ;

identifiant une capacité totale déchargée par la batterie (102) sur la base de la valeur de tension de la batterie (102) ; et

comparant la capacité totale pour une utilisation correspondante parmi les une ou plusieurs utilisations avec un état de santé de capacité de la batterie (102), pour estimer les une ou plusieurs capacités dynamiques pour les une ou plusieurs utilisations.

100

102

103

ESTIMATION UNIT
**101**

PROCESSOR
**105**

I/O INTERFACE
**106**

COMMUNICATION
NETWORK
**104**

MEMORY **107**

MODULES
**108**

DATA
**109**

**Figure 1**

## ESTIMATION UNIT
### 101

| PROCESSOR 105 | I/O INTERFACE 106 |

### MEMORY 107

#### MODULES 108

| SOH RECEPTION MODULE 201 | VOLTAGE PROFILE PREDICTION MODULE 202 |
| DYNAMIC CAPACITY ESTIMATION MODULE 203 | LONGEVITY INDEX DETERMINATION MODULE 204 |
| BREAKDOWN INDEX PREDICTION MODULE 205 | OTHER MODULES 206 |

#### DATA 109

| SOH DATA 207 | GEO-LOCATION DATA 208 |
| USAGE DATA 209 | VOLTAGE PROFILE DATA 210 |
| DYNAMIC CAPACITY DATA 211 | LONGEVITY INDEX DATA 212 |
| BREAKDOWN INDEX DATA 213 | LOAD PROFILE DATA 214 |
| ENERGY INFORMATION DATA 215 | OTHER DATA 216 |

Figure 2

DISCHARGE RATE OF
BATTERY

300a

REAL-TIME
BATTERY DATA → VOLTAGE WINDOW DETERMINATION UNIT **301** → OCV WINDOW ESTIMATION UNIT **303** → FIRST OCV PROFILE ESTIMATION UNIT **304** → IDEAL VOLTAGE PROFILE PREDICTION UNIT **305** → IDEAL VOLTAGE

RESISTANCE BEHAVIOUR DETERMINATION UNIT **302**

**Figure 3a**

Figure 3b

300c

DISCHARGE RATE OF
BATTERY

| ENERGY ESTIMATION UNIT FOR FUTURE JOURNEY INFORMATION 308 | SOC PROFILE ESTIMATION UNIT 310 | SECOND OCV PROFILE ESTIMATION UNIT 311 | REAL-TIME VOLTAGE PROFILE PREDICTION UNIT 312 |

REAL-TIME VOLTAGE

SOC ESTIMATION UNIT OF BATTERY 309

RESISTANCE BEHAVIOUR DETERMINATION UNIT 302

**Figure 3c**

Figure 3d

400a

REAL-TIME
BATTERY DATA

BATTERY PACK
MODEL
**401**

SOHQ

SOHR

IDEAL VOLTAGE
PROFILE
PREDICTION UNIT
**402**

DYNAMIC
CAPACITY
ESTIMATION UNIT
**404**

DYNAMIC CAPACITY FOR
SMOOTHER USAGE

DYNAMIC CAPACITY FOR
PRESENT USAGE

DYNAMIC CAPACITY FOR
AGGRESSIVE USAGE

REAL-TIME
VOLTAGE
PROFILE
PREDICTION UNIT
**403**

ONE OR MORE
USAGES

GEO-LOCATION
DATA

PREDICTED LOAD
PROFILE

**Figure 4a**

IDEAL VOLTAGE PROFILE

REAL-TIME VOLTAGE PROFILE

CAPACITY

VOLTAGE OF BATTERY

LOWER LIMIT

SOC OF BATTERY

405

406

407

**Figure 4b**

**Figure 5**

600

DYNAMIC CAPACITY FOR
ONE OR MORE USAGES

DYNAMIC
CAPACITY

601

602

603

ENERGY INFORMATION

BREAKDOWN
INDEX

TIME

**Figure 6**

700

RECEIVE STATE OF HEALTH DATA OF BATTERY OF ELECTRIC
VEHICLE
**701**

PREDICT ONE OR MORE VOLTAGE PROFILES BASED ON AT LEAST
ONE OF STATE OF HEALTH DATA, GEO-LOCATION DATA AND ONE
OR MORE LOAD PROFILES
**702**

ESTIMATE ONE OR MORE DYNAMIC CAPACITIES BASED ON ONE
OR MORE VOLTAGE PROFILES
**703**

DETERMINE LONGEVITY INDEX OF BATTERY BASED ON ONE OR
MORE DYNAMIC CAPACITIES
**704**

PREDICT BREAKDOWN INDEX OF BATTERY BASED ON ONE OR
MORE DYNAMIC CAPACITIES AND ENERGY INFORMATION
**705**

**Figure 7**

**Figure 8**

**EP 4 137 345 B1**

**REFERENCES CITED IN THE DESCRIPTION**

**Patent documents cited in the description**

- EP 3283893 A
- US 2021242510 A1
- US 2015070 A
- US 024 A
- EP 2680395 A